# EUROPEAN PATENT SPECIFICATION

(11) **EP 3 902 088 B1**
(45) Date of publication and mention of the grant of the patent: **14.06.2023**
(21) Application number: 19899742.1
(22) Date of filing: 21.08.2019
(51) Int. Cl.: H02J 7/00, B60L 3/00, B60L 58/12, G01R 31/378, H01M 10/44, H01M 10/48, B60L 58/13, G01R 31/382, H01M 10/42

(54) **BATTERY CONTROL SYSTEM AND SADDLED VEHICLE**
BATTERIESTEUERUNGSSYSTEM UND SATTELFAHRZEUG
SYSTÈME DE COMMANDE DE BATTERIE ET VÉHICULE DE TYPE À SELLE

(30) Priority: 18.12.2018 JP 2018236281
(43) Date of publication of application: 27.10.2021
(73) Proprietor: Yamaha Hatsudoki Kabushiki Kaisha, Iwata-shi, Shizuoka 438-8501 (JP)
(72) Inventor: YAMAMOTO, Kazuki, Iwata-shi, Shizuoka 438-8501 (JP); ITO, Masaki, Iwata-shi, Shizuoka 438-8501 (JP); KONDOH, Kohji, Iwata-shi, Shizuoka 438-8501 (JP)
(74) Representative: Grünecker Patent- und Rechtsanwälte PartG mbB
(86) International application number: PCT/JP2019/032672
(87) International publication number: WO 2020/129301

(56) References cited:
- JP-A- 2000 312 404
- JP-A- 2008 170 196
- JP-A- 2017 221 076
- JP-A- 2018 007 410
- US-A1- 2012 200 257

## Description

The present invention relates to a battery control system and a straddled vehicle having the battery control system. Regarding relevant background art a battery control system can be taken from the prior art document US 2012/200257 A1, wherein all features in the preamble of independent claim 1 of the present invention appear disclosed in combination.

A vehicle using an internal combustion engine (hereinafter referred to as an "engine") as its power source typically includes a rotating electrical machine installed thereon that generates electric power using the rotation of the engine.

Patent Document Nos. 1 and 2 each disclose a straddled vehicle that uses an electric power-generating rotating electrical machine as a starter motor for driving the crank shaft of the engine at the start of the engine and as an assisting motor for assisting the power of the engine as needed while running.

### CITATION LIST

### PATENT LITERATURE

Patent Document No. 1: Japanese Laid-Open Patent Publication No. 2004-122925
Patent Document No. 2: Japanese Laid-Open Patent Publication No. 2008-24255

One may consider using a nickel-metal hydride battery as the secondary battery of such a rotating electrical machine. A nickel-metal hydride battery is available at relatively low cost, and it is possible to reduce the cost of the vehicle. It is possible to rotate the rotating electrical machine by supplying electric power to the rotating electrical machine from the nickel-metal hydride battery. Moreover, while generating power, the nickel-metal hydride battery can store electric power generated by the rotating electrical machine.

However, a characteristic of a nickel-metal hydride battery is that the charging efficiency lowers when the temperature is high and the output lowers when the temperature is low. A nickel-metal hydride battery also has a problem in that it has a hysteresis and a memory effect for the relationship between voltage and SOC (State Of Charge), thereby complicating the charge/discharge control.

With this characteristic of a nickel-metal hydride battery, one may consider, for a nickel-metal hydride battery for use on a vehicle, charging/discharging only over a narrow SOC range (e.g., a 40-60% range) in order to realize a stable charge/discharge control. By limiting the SOC use range to a narrow range, it is possible to realize a stable control that reduces the influence of the lowering of the charging efficiency and the lowering of the output.

On the other hand, in order to make effective use of the performance of a nickel-metal hydride battery, it is desirable to charge/discharge over a wide SOC range. In order to appropriately control charging/discharging over a wide SOC range, it is desirable to precisely grasp the state of the memory effect of the nickel-metal hydride battery.

Ii is the object of the present invention to provide a battery control system, with which it is possible to precisely grasp the state of the memory effect of a nickel-metal hydride battery, and a straddled vehicle having such a battery control system. According to the present invention said object is solved by a battery control system having the features of independent claim 1. Preferred embodiments are laid down in the dependent claims.

The present invention is directed to a battery control system for controlling charging/discharging of a nickel-metal hydride battery having a hysteresis characteristic for a relationship between voltage and SOC (State Of Charge), the battery control system including: a storage medium that stores information regarding a plurality of SOC use ranges having different SOC upper and lower limits; and a control circuit that selects one of the plurality of SOC use ranges depending on a condition of use according to a temperature of the nickel-metal hydride battery to control the charging/discharging of the nickel-metal hydride battery in accordance with the selected SOC use range, wherein: the plurality of SOC use ranges include a first use range, and a second use range that includes an SOC of the same level as the SOC lower limit of the first use range; the control circuit: detects a voltage of the nickel-metal hydride battery and calculates the state of charge therefrom; determines whether a current SOC of the nickel-metal hydride battery is equal to a predetermined SOC that is included in both the first and second use ranges; when it is determined that the current SOC is equal to the predetermined SOC, obtains information regarding a memory effect of the nickel-metal hydride battery; and controls the discharging of the nickel-metal hydride battery by lowering a lower limit voltage of each of the state of charge use ranges using the obtained information regarding the memory effect.

By selectively using a plurality of SOC use ranges depending on the condition of use of the nickel-metal hydride battery, it is possible to charge/discharge over a wide SOC range. Being able to charge/discharge over a wide SOC range, it is possible to make effective use of the performance of the nickel-metal hydride battery.

On the other hand, the discharge curves of the SOC use ranges are different from each other. Therefore, in embodiments where a plurality of SOC use ranges are selectively used, it is difficult to precisely detect the memory effect.

As already mentioned, the predetermined SOC that corresponds to the SOC lower limit of the first use range is included in both of the first and second use ranges. Irrespective of which one of the first and second use ranges is selected, there exists a point in time at which the SOC of the nickel-metal hydride battery becomes equal to the predetermined SOC as the SOC transitions. When it is determined that the current SOC of the nickel-metal hydride battery is equal to the predetermined SOC, information regarding the memory effect is obtained. Thus, it is possible to precisely detect the memory effect.

For example, at the predetermined SOC that corresponds to the SOC lower limit of the first use range, the difference is small between the voltage along the discharge curve of the first use range and the voltage along the discharge curve of the second use range. The voltage of the nickel-metal hydride battery at a point in time when the SOC becomes equal to the predetermined SOC, at which the voltage difference is small, is detected. By using the voltage value that is detected in the region where the voltage difference is small between the SOC use ranges, it is possible to precisely detect the voltage drop due to the memory effect. By precisely detecting the voltage drop due to the memory effect, it becomes easy to repeat the charging/discharging in the selected SOC use range, and it is also possible to refresh the nickel-metal hydride battery with appropriate timing if refreshing is needed.

For example, the number of times the SOC of the nickel-metal hydride battery becomes equal to the predetermined SOC is counted. Based on the counted number of times, it is possible to grasp the development of the memory effect of the nickel-metal hydride battery. Then, it becomes easy to repeat the charging/discharging in the selected SOC use range, and it is also possible to refresh the nickel-metal hydride battery with appropriate timing when refreshing is needed. By counting the number of times at a predetermined SOC that is included in both of the first and second use ranges, it is possible to precisely count the number of times without failing to count the number of times irrespective of which one of the first and second use ranges is selected.

In one embodiment, the control circuit may: when it is determined that the current SOC is equal to the predetermined SOC, detect a voltage of the nickel-metal hydride battery at the predetermined SOC using information regarding the voltage of the nickel-metal hydride battery detected by a voltage sensor; and control the discharging of the nickel-metal hydride battery using the voltage of the nickel-metal hydride battery at the predetermined SOC.

At the predetermined SOC that corresponds to the SOC lower limit of the first use range, the difference is small between the voltage along the discharge curve of the first use range and the voltage along the discharge curve of the second use range. The voltage of the nickel-metal hydride battery at a point in time when the SOC becomes equal to the predetermined SOC, at which the voltage difference is small, is detected. By using the voltage value that is detected in the region where the voltage difference is small between the SOC use ranges, it is possible to precisely detect the voltage drop due to the memory effect.

In one embodiment, the control circuit may: determine whether the voltage at the predetermined SOC is less than or equal to a predetermined voltage; and when it is determined that the voltage at the predetermined SOC is less than or equal to the predetermined voltage, perform a control of refreshing the nickel-metal hydride battery.

By using the voltage value that is detected in the region where the voltage difference is small between the SOC use ranges, it is possible to precisely detect the voltage drop due to the memory effect. By precisely detecting the voltage drop due to the memory effect, it is possible to refresh the nickel-metal hydride battery with appropriate timing.

In one embodiment, the control circuit may correct a value of the detected voltage in accordance with the currently-selected SOC use range of the plurality of SOC use ranges.

The voltage value at the predetermined SOC somewhat varies between different SOC use ranges. By correcting the voltage value in accordance with the currently-selected SOC use range, it is possible to more precisely detect the voltage drop due to the memory effect.

In one embodiment, the control circuit may count the number of times the SOC of the nickel-metal hydride battery becomes equal to the predetermined SOC; determine whether the counted number of times is greater than or equal to a predetermined number of times; and when it is determined that the counted number of times is greater than or equal to the predetermined number of times, perform a control of refreshing the nickel-metal hydride battery.

As the nickel-metal hydride battery is repeatedly charged/discharged, the memory effect develops, thereby decreasing the voltage that is obtained while discharging. When the counted number of times becomes greater than or equal to the predetermined number of times, the nickel-metal hydride battery is refreshed. Thus, it is possible to restore the voltage that is obtained while discharging.

By counting the number of times at a predetermined SOC that is included in both of the first and second use ranges, it is possible to precisely count the number of times without failing to count the number of times irrespective of which one of the first and second use ranges is selected.

In one embodiment, the control circuit may: count the number of times the SOC of the nickel-metal hydride battery becomes equal to the predetermined SOC; and set a lower limit of a voltage of a discharge curve of each of the plurality of SOC use ranges to be lower than a current set value depending on the counted number of times.

The lower limit of the voltage of the discharge curve is lowered depending on the voltage drop due to the memory effect. Thus, it is possible to suppress narrowing of the SOC range that is actually used even if the memory effect develops.

In one embodiment, the predetermined SOC may be smaller than 50% and greater than or equal to the SOC lower limit of the first use range.

The memory effect is likely to occur particularly in the region where SOC is less than 50% as compared with the region where SOC is 50% or more. As the region where information regarding the memory effect is obtained is set to the region where SOC is less than 50%, it is possible to perform a more appropriate discharge control.

In an example not covered by the present invention, the control circuit may: calculate a cumulative value of a current that is output from the nickel-metal hydride battery using information regarding a current of the nickel-metal hydride battery detected by a current sensor; and calculate the current SOC of the nickel-metal hydride battery using the cumulative current value.

In one embodiment, the SOC upper limit of the first use range may be higher than the SOC upper limit of the second use range; and the SOC lower limit of the second use range may be lower than the SOC lower limit of the first use range.

By selectively using the first use range having a high SOC upper limit and the second use range having a low SOC lower limit, it is possible to charge/discharge the nickel-metal hydride battery over a wide SOC range.

In one embodiment, the plurality of SOC use ranges may further include a third use range; an SOC upper limit of the third use range may be lower than the SOC upper limit of the first use range and higher than the SOC upper limit of the second use range; an SOC lower limit of the third use range may be lower than the SOC lower limit of the first use range and higher than the SOC lower limit of the second use range; and the third use range may include a predetermined SOC that corresponds to the SOC lower limit of the first use range.

By selectively using the first, second and third use ranges, it is possible to charge/discharge the nickel-metal hydride battery over a wide SOC range.

The predetermined SOC that corresponds to the SOC lower limit of the first use range is included in all of the first, second and third use ranges. Irrespective of which one of the first, second and third use ranges is selected, there exists a point in time at which the SOC of the nickel-metal hydride battery becomes equal to the predetermined SOC as the SOC transitions. When it is determined that the current SOC of the nickel-metal hydride battery is equal to the predetermined SOC, information regarding the memory effect is obtained. Thus, it is possible to precisely detect the memory effect.

By selectively using a plurality of SOC use ranges depending on the temperature of the nickel-metal hydride battery, it is possible to charge/discharge over a wide SOC range. Being able to charge/discharge over a wide SOC range, it is possible to make effective use of the performance of the nickel-metal hydride battery.

In one embodiment, the predetermined SOC may be of a level of the SOC lower limit of the first use range.

The SOC of the level at the lower limit of the first use range is included in each of the use ranges. Irrespective of which one of the use ranges is selected, there exists a point in time at which the SOC of the nickel-metal hydride battery becomes equal to the predetermined SOC as the SOC transitions. When it is determined that the current SOC of the nickel-metal hydride battery is equal to the predetermined SOC, information regarding the memory effect is obtained. Thus, it is possible to precisely detect the memory effect.

In one embodiment, at the time of initial use of the nickel-metal hydride battery, the control circuit may: charge the nickel-metal hydride battery to the SOC upper limit of the first use range; after charging the nickel-metal hydride battery to the SOC upper limit of the first use range, discharge the nickel-metal hydride battery to the lower limit of the SOC use range selected depending on a condition of use according to a temperature of the nickel-metal hydride battery; and after discharging the nickel-metal hydride battery to the lower limit of the selected SOC use range, charge the nickel-metal hydride battery to the SOC upper limit of the second use range selected depending on the condition of use according to the temperature of the nickel-metal hydride battery.

By discharging to the SOC lower limit of the second use range and charging to the SOC upper limit of the first use range, the discharge curve and the charge curve (a discharge curve and a charge curve that are to be the reference) are obtained that connect together the SOC upper limit of the first use range and the SOC lower limit of the second use range.

At the time of initial use of the nickel-metal hydride battery, the discharge curve obtained when the second use range is selected is apart from the discharge curve to be the reference. In the process of repeating a control of changing the SOC use range depending on the condition of use of the nickel-metal hydride battery, the discharge curve of the second use range moves closer to the discharge curve to be the reference. If the discharge curve of the second use range moves in the process of repeating a control of changing the SOC use range, it is difficult to precisely detect the memory effect.

In view of this, at the time of initial use of the nickel-metal hydride battery, the nickel-metal hydride battery is charged to the SOC upper limit of the first use range, and then discharged to the lower limit of the SOC use range selected depending on the condition of use of the nickel-metal hydride battery. After discharged to the lower limit, the nickel-metal hydride battery is charged to the upper limit of the second use range selected depending on the condition of use. Thus, the discharge curve of the second use range can immediately be made to conform to the discharge curve to be the reference. After the discharge curve of the second use range is made to conform to the discharge curve to be the reference, the discharge curve does not move except by the influence of the memory effect. As the discharge curve of the second use range no longer moves, it is possible to precisely detect the memory effect.

In one embodiment, the initial use of the nickel-metal hydride battery may be a first use of the nickel-metal hydride battery after shipping of the nickel-metal hydride battery.

Immediately after starting to use the nickel-metal hydride battery, the discharge curve of the second use range can be made to conform to the discharge curve to be the reference. As the discharge curve of the second use range no longer moves except by the influence of the memory effect, it is possible to precisely detect the memory effect.

In one embodiment, the initial use of the nickel-metal hydride battery may be a first use of the nickel-metal hydride battery after replenishing charging of the nickel-metal hydride battery.

Immediately after starting to use the nickel-metal hydride battery after the replenishing charging, the discharge curve of the second use range can be made to conform to the discharge curve to be the reference. As the discharge curve of the second use range no longer moves except by the influence of the memory effect, it is possible to precisely detect the memory effect.

A straddled vehicle according to an embodiment includes the battery control system described above.

Being able to charge/discharge the nickel-metal hydride battery over a wide SOC range and to appropriately control the memory effect, it is possible to improve the performance of the straddled vehicle.

### ADVANTAGEOUS EFFECTS OF INVENTION

With the battery control system according to an illustrative embodiment, a predetermined SOC that corresponds to the SOC lower limit of the first use range is included in both of the first and second use ranges. Irrespective of which one of the first and second use ranges is selected, there exists a point in time at which the SOC of the nickel-metal hydride battery becomes equal to the predetermined SOC as the SOC transitions. When it is determined that the current SOC of the nickel-metal hydride battery is equal to the predetermined SOC, information regarding the memory effect is obtained. Thus, it is possible to precisely detect the memory effect.

### BRIEF DESCRIPTION OF DRAWINGS

FIG. **1** is a side view showing a motorcycle according to an embodiment.
FIG. **2** shows an engine unit according to an embodiment.
FIG. **3** shows an engine unit according to an embodiment.
FIG. **4** is a block diagram showing an engine system according to an embodiment.
FIG. **5** shows a charging/discharging characteristic of a nickel-metal hydride battery according to an embodiment.
FIG. **6** shows an SOC use range used when the temperature of a nickel-metal hydride battery is a low temperature according to an embodiment.
FIG. **7** shows an SOC use range used when the temperature of a nickel-metal hydride battery is a medium temperature according to an embodiment.
FIG. **8** shows an SOC use range used when the temperature of a nickel-metal hydride battery is a high temperature according to an embodiment.
FIG. **9** is a flow chart showing a process of changing the SOC use range depending on the temperature of a nickel-metal hydride battery according to an embodiment.
FIG. **10** is a flow chart showing a charging/discharging control in accordance with the current SOC of a nickel-metal hydride battery.
FIG. **11** is a flow chart showing a control performed in conjunction with the memory effect of a nickel-metal hydride battery according to an embodiment.
FIG. **12** is a flow chart showing another example control performed in conjunction with the memory effect of a nickel-metal hydride battery according to an embodiment.
FIG. **13** shows an SOC use range for low temperature, an SOC use range for medium temperature and an SOC use range for high temperature according to an embodiment.
FIG. **14** shows an example of how a nickel-metal hydride battery is charged/discharged when a lower limit detection condition is not satisfied according to an embodiment.
FIG. **15** shows an example of how a nickel-metal hydride battery is charged/discharged when a lower limit detection condition is satisfied according to an embodiment.
FIG. **16** shows how the memory effect develops according to an embodiment.
FIG. **17** shows a control of lowering the lower limit voltage of a discharge curve depending on a count according to an embodiment.
FIG. **18** is a flow chart showing a control of refreshing a nickel-metal hydride battery according to an embodiment.
FIG. **19** shows a charging/discharging characteristic when a period has not elapsed since the first use of a nickel-metal hydride battery after shipping according to an embodiment.
FIG. **20** shows how discharge curves move according to an embodiment.
FIG. **21** is a flow chart showing an initial charge/discharge control of a nickel-metal hydride battery according to an embodiment.
FIG. **22** is a flow chart showing an initial charge/discharge control of a nickel-metal hydride battery according to an embodiment.

### DESCRIPTION OF EMBODIMENTS

An embodiment of the battery control system will now be described with reference to the drawings. Like elements are denoted by like reference signs, and will not be described redundantly. The terms front, rear, up, down, left and right, as used in the description below, refer to these directions as seen from a passenger seated in the seat of the straddled vehicle.

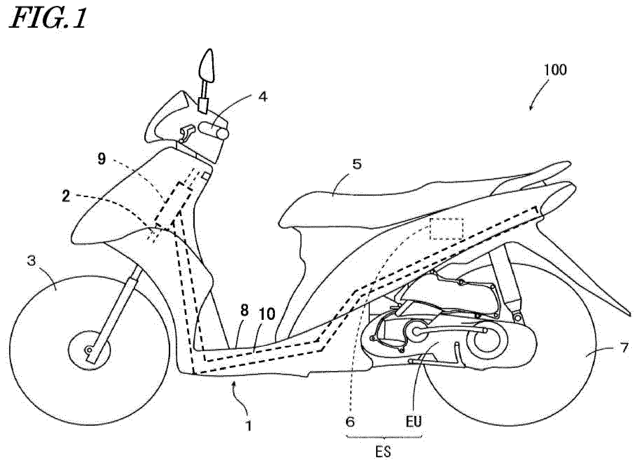

FIG. **1** is a side view showing a motorcycle **100,** which is an example of a straddled vehicle according to the embodiment. In the example shown in FIG. **1****,** the straddled vehicle is a scooter-type motorcycle. Note that the straddled vehicle according to the embodiment is not limited to a scooter-type motorcycle as illustrated herein. The straddled vehicle according to the embodiment may be a motorcycle of any other type such as so-called on-road type, off-road type or moped type. The straddled vehicle according to the embodiment refers to any vehicle that is straddled by a passenger, and is not limited to a two-wheeled vehicle. The straddled vehicle according to the embodiment may be a three-wheeled vehicle of which the direction of travel is changed by leaning the vehicle body (LMW), or the like, or may be any other straddled vehicle such as an ATV (All Terrain Vehicle).

The motorcycle **100** includes a rotating electrical machine that functions as a starter/electric generator. The rotating electrical machine generates electric power using the rotation. The rotating electrical machine is used as a starter motor for driving the crank shaft of the engine at the start of the engine, and also as an assisting motor for assisting the power of the engine while running. The rotating electrical machine functioning as an assisting motor may be referred to herein simply as a "motor" herein.

The motorcycle **100** shown in FIG. **1** includes a body frame **10** including a head pipe **9,** a handle **4** supported on the head pipe **9,** a seat **5** provided rearward of the handle **4,** and a leg space **8** that is provided between the handle **4** and the seat **5** and is used by the rider to rest his/her feet thereon.

The head pipe **9** supports a front fork **2** so that the front fork **2** can swivel left and right. The handle **4** is attached to the upper end of the front fork **2,** and a front wheel **3** is rotatably attached to the lower end of the front fork **2.**

The seat **5** is provided on an upper portion of generally the center of the body **1.** An ECU (Engine Control Unit) **6** and an engine unit **EU** are provided under the seat **5.** The ECU **6** and the engine unit **EU** together form the engine system **ES.** A rear wheel **7** is rotatably attached to a lower portion of the rear end of the body **1.** The rear wheel **7** is driven by the power generated by the engine unit **EU.**

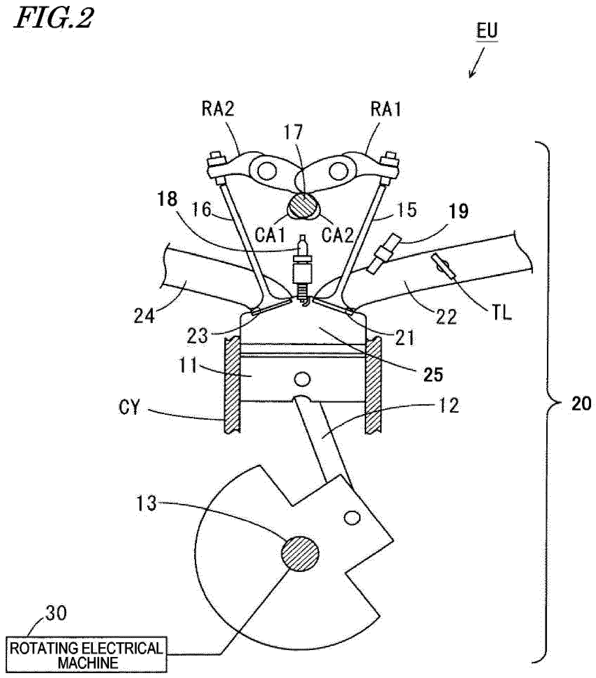

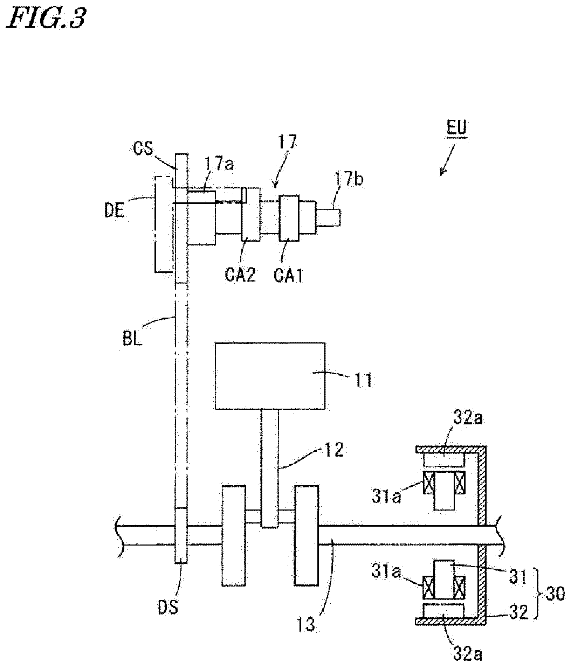

FIG. **2** and FIG. **3** are schematic diagrams of the engine unit **EU.** As shown in FIG. **2****,** the engine unit **EU** includes an engine **20** and a rotating electrical machine **30.** The rotating electrical machine **30** functions as a starter/electric generator. FIG. **2** and FIG. **3** show a 4-stroke single-cylinder engine as an example of the engine **20.** The engine **20** includes a cylinder **CY,** a piston **11,** a conrod (connecting rod) **12,** a crank shaft **13,** an intake valve **15,** an exhaust valve **16,** a cam shaft **17,** an injector **19** and an ignitor **18.**

The piston **11** is reciprocally provided in the cylinder **CY,** and is connected to the crank shaft **13** via the conrod **12.** The cylinder **CY** and the piston **11** together define a combustion chamber **25.** The combustion chamber **25** communicates with an intake passageway **22** via an intake port **21,** and communicates with an exhaust passageway **24** via an exhaust port **23.** The intake valve **15** is provided so as to open/close the intake port **21,** and the exhaust valve **16** is provided so as to open/close the exhaust port **23.** The throttle valve **TL** is provided along the intake passageway **22** for adjusting the flow rate of the air to be guided into the combustion chamber **25.** The opening of the throttle valve **TL** is adjusted by operating the accelerator grip (not shown) provided on the handle **4** (FIG. **1**).

The injector **19** injects fuel into the intake passageway **22.** The ignitor **18** ignites the fuel mixture in the combustion chamber **25.** Fuel injected by the injector **19** is mixed with the air and guided into the combustion chamber **25,** and the fuel mixture is ignited in the combustion chamber **25** by the ignitor **18.** The combustion of the fuel mixture drives the piston **11,** and the reciprocation of the piston **11** is converted into the rotation of the crank shaft **13.** The torque of the crank shaft **13** is transmitted to the rear wheel **7** of FIG. **1****,** thereby driving the rear wheel **7.**

The cam shaft **17** is provided so as to rotate together with the rotation of the crank shaft **13.** Rocker arms **RA1** and **RA2** are provided in contact with the cam shaft **17** so that they can swivel. The cam shaft **17** drives the intake valve **15** via the rocker arm **RA1,** and the exhaust valve **16** via the rocker arm **RA2.**

As shown in FIG. **3****,** a cam sprocket **CS** is provided at one end of the cam shaft **17.** A cam shaft drive sprocket **DS** is provided on the crank shaft **13.** A belt **BL** is wound between the cam sprocket **CS** and the cam shaft drive sprocket **DS.** The torque of the crank shaft **13** is transmitted to the cam shaft **17** via the belt **BL.** The rotation speed of the cam shaft **17** is 1/2 the rotation speed of the crank shaft **13,** for example.

The cam shaft **17** has cam journals **17a** and **17b,** an intake cam **CA1** and an exhaust cam **CA2.** The cam journal **17a** is arranged so as to be next to the cam sprocket **CS,** and the cam journal **17b** is arranged at the other end of the cam shaft **17.** The cam journals **17a** and **17b** are each held by a bearing (not shown) . The intake cam **CA1** and the exhaust cam **CA2** are provided between the cam journals **17a** and **17b.** The intake cam **CA1** is provided so as to be next to the cam journal **17b,** and the exhaust cam **CA2** is provided so as to be next to the cam journal **17a.** The intake cam **CA1** drives the rocker arm **RA1** of FIG. **2** when the crank angle (rotational position of the crank shaft **13**) is within an angle range corresponding to the intake cycle. The exhaust cam **CA2** drives the rocker arm **RA2** of FIG. **2** when the crank angle is within an angle range corresponding to the exhaust cycle.

A decompression mechanism **DE** is provided on the cam shaft **17.** The decompression mechanism **DE** lifts the exhaust valve **16,** independently of the exhaust cam **CA2,** to lower the pressure in the cylinder **CY.** The decompression mechanism is known in the art, and will not be described below.

The rotating electrical machine **30** includes a stator **31** and a rotor **32.** The stator **31** is secured on a crank case (not shown), and includes a plurality of stator coils **31a** of U, V and W phases. The stator coils **31a** are arranged along a circle that is centered about the rotational center of the crank shaft **13.** The rotor **32** is secured on the crank shaft **13** so as to surround the stator **31.** The rotor **32** includes a plurality of permanent magnets **32a.** The plurality of permanent magnets **32a** are arranged along a circle that is centered about the rotational center of the crank shaft **13.** The rotating electrical machine **30** is capable of driving the crank shaft **13** using the electric power supplied from a nickel-metal hydride battery to be described below. The rotating electrical machine **30** can generate electric power from the rotation transmitted from the crank shaft **13.** The nickel-metal hydride battery can be charged using the generated electric power. Note that a starter motor and a generator may be provided separately instead of the rotating electrical machine **30.**

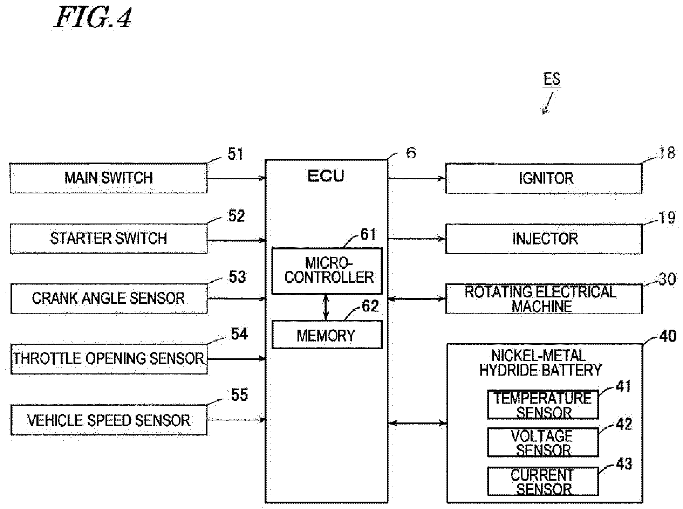

FIG. **4** is a block diagram showing the engine system **ES**. The engine system **ES** operates by using electric power stored in a nickel-metal hydride battery **40** and electric power generated by the rotating electrical machine **30,** for example. The engine system **ES** may include a battery for its operation, separately from the nickel-metal hydride battery **40.**

The engine system **ES** includes a crank angle sensor **53,** a throttle opening sensor **54** and a vehicle speed sensor **55.** The ECU **6** can detect various states of the motorcycle **100** by using the outputs from these sensors.

The crank angle sensor **53** is a sensor for detecting the crank angle. By detecting the crank angle, it is possible to obtain the rotation speed (e.g., the number of revolutions per minute, rpm) of the engine **20.** The throttle opening sensor **54** detects the opening of the throttle valve **TL** of FIG. **2**. The vehicle speed sensor **55** detects the running speed (vehicle speed) of the motorcycle **100.** The crank angle sensor **53,** the throttle opening sensor **54** and the vehicle speed sensor **55** each output a detection signal in accordance with the detection results to the ECU **6.**

A main switch **51** and a starter switch **52** are provided on the handle **4** (FIG. **1**), for example. Operation signals in accordance with the rider's operation of the main switch **51** and the starter switch **52** are output to the ECU **6.**

The nickel-metal hydride battery **40** is provided with a temperature sensor **41,** a voltage sensor **42** and a current sensor **43.** The temperature sensor **41** detects the temperature of the nickel-metal hydride battery **40.** The temperature sensor **41** may be any temperature sensor, e.g., a thermistor, a thermocouple, etc. The voltage sensor **42** detects the terminal voltage of the nickel-metal hydride battery **40.** The current sensor **43** detects the current flowing through the nickel-metal hydride battery **40.** The temperature sensor **41,** the voltage sensor **42** and the current sensor **43** each output a detection signal in accordance with the detection results to the ECU **6.**

The ECU **6** includes a microcontroller **61** and a memory **62,** for example. Based on detection signals and operation signals given thereto, the ECU **6** controls the ignitor **18,** the injector **19,** the rotating electrical machine **30** and the nickel-metal hydride battery **40.**

For example, when the main switch **51** is turned ON and the starter switch **52** is turned ON, the ECU **6** actuates the rotating electrical machine **30** to drive the crank shaft **13** of the engine **20.** Thus, the engine **20** starts. The start of the engine **20** refers to the start of the combustion of a fuel mixture when the fuel injection by the injector **19** and the ignition by the ignitor **18** start.

When the motorcycle **100** stops and the main switch **51** is turned OFF, the engine **20** stops. The stopping of the engine **20** refers to the discontinuation of the combustion of a fuel mixture following the discontinuation of at least one of the fuel injection by the injector **19** and the ignition by the ignitor **18.**

The ECU **6** of the present embodiment serves also as a battery control system for controlling the charging and discharging of the nickel-metal hydride battery **40.** The control of the charging and discharging depending on the temperature of the nickel-metal hydride battery **40** will now be described. A control performed depending on the state of the memory effect of the nickel-metal hydride battery **40** will also be described.

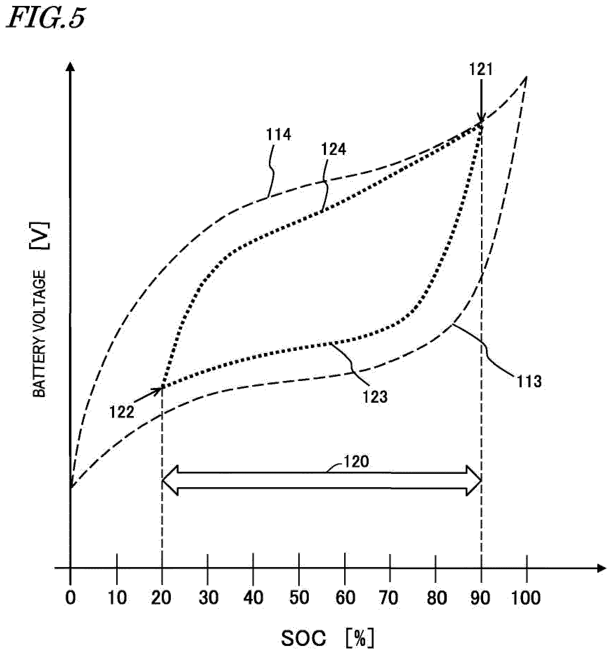

FIG. **5** shows a charging/discharging characteristic of the nickel-metal hydride battery **40.** The vertical axis of FIG. **5** shows battery voltage, and the horizontal axis thereof shows SOC (State Of Charge).

Battery voltage shown on the vertical axis is the open circuit voltage (OCV), for example. For example, the microcontroller **61** can calculate the open circuit voltage by using the voltage value and the current value obtained from the voltage sensor **42** and the current sensor **43.** Any of various methods known in the art can be used as the method for calculating the open circuit voltage, which will not be herein described in detail. Note that it is possible to perform the control process of the present embodiment also by using the closed circuit voltage (CCV) instead of the open circuit voltage. SOC shown on the horizontal axis represents, in percentage, the amount of electricity currently charged relative to the capacity of the battery.

A discharge curve **113** shows the relationship between battery voltage and SOC when the nickel-metal hydride battery **40** is discharged from 100% SOC to 0% SOC. A charge curve **114** shows the relationship between battery voltage and SOC when the nickel-metal hydride battery **40** is charged from 0% SOC to 100% SOC.

A discharge curve **123** shows the relationship between battery voltage and SOC when the nickel-metal hydride battery **40** is discharged from 90% SOC to 20% SOC. A charge curve **124** shows the relationship between battery voltage and SOC when the nickel-metal hydride battery **40** is charged from 20% SOC to 90% SOC.

The memory **62** stores discharge curves, charge curves and SOC use ranges. The microcontroller **61** can obtain SOC from battery voltage by using a discharge curve and a charge curve read out from the memory **62.**

FIG. **5** shows an SOC use range **120.** In the illustrated example, SOC is 90% at an upper limit **121** of the SOC use range **120** and 20% at a lower limit **122** thereof. When the nickel-metal hydride battery **40** is charged until SOC reaches 90% and then discharged, the nickel-metal hydride battery **40** is discharged in accordance with the relationship between battery voltage and SOC along the discharge curve **123.** While discharging, the microcontroller **61** uses the output of the nickel-metal hydride battery **40** for the operation of various components of the engine system **ES.** For example, electric power stored in the nickel-metal hydride battery **40** is consumed by performing a control such that the rotating electrical machine **30** generates output for assisting the engine **20** while the vehicle is running.

When the nickel-metal hydride battery **40** is discharged until SOC reaches 20% and then charged, the nickel-metal hydride battery **40** is charged in accordance with the relationship between battery voltage and SOC along the charge curve **124.** While charging, the microcontroller **61** performs a control such that electric power generated by the rotating electrical machine **30** is supplied to the nickel-metal hydride battery **40.** Thus, the nickel-metal hydride battery **40** can be charged.

As shown in FIG. **5****,** the nickel-metal hydride battery **40** has a hysteresis characteristic wherein the discharge curve and the charge curve are significantly different from each other. The hysteresis characteristic of the nickel-metal hydride battery **40** complicates the charge/discharge control. Moreover, the nickel-metal hydride battery **40** has a characteristic such that the charging efficiency lowers when the temperature is high and the output lowers when the temperature is low. Therefore, it is not easy to realize stable charging/discharging over a wide SOC use range (e.g., an SOC range from 20% to 90%).

In view of this, when controlling the charging/discharging of the nickel-metal hydride battery **40** of the present embodiment, a plurality of SOC use ranges having different SOC upper and lower limits are selectively used depending on the temperature of the nickel-metal hydride battery **40.**

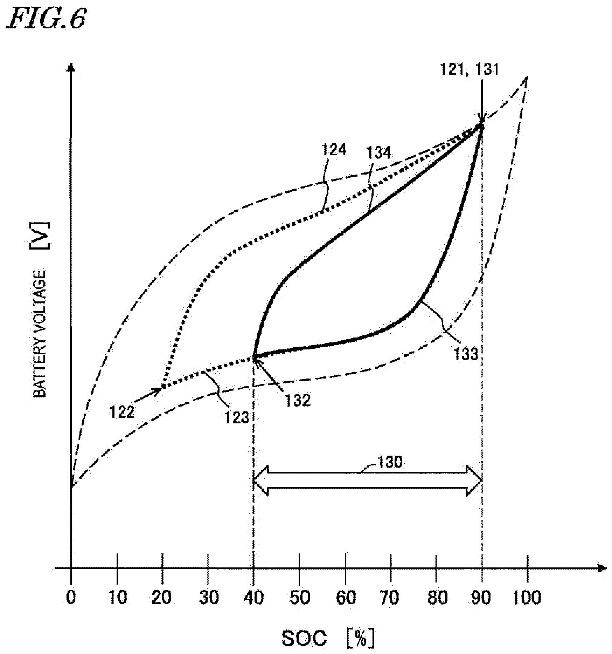

FIG. **6** shows an SOC use range **130** used when the temperature of the nickel-metal hydride battery **40** is a low temperature. The vertical axis of FIG. **6** shows battery voltage and the horizontal axis thereof shows SOC. The nickel-metal hydride battery **40** being at a low temperature means that the temperature of the nickel-metal hydride battery **40** is less than 10°C, for example.

In the example shown in FIG. **6****,** SOC is 90% at an upper limit **131** of the SOC use range **130** and 40% at a lower limit **132** thereof. The nickel-metal hydride battery **40** has a characteristic such that the output lowers when the temperature is low. Therefore, when the temperature of the nickel-metal hydride battery **40** is low, the nickel-metal hydride battery **40** is charged/discharged over a use range such that SOC does not become too low. When the temperature is low, the microcontroller **61** controls the charging/discharging over the SOC use range **130,** which is a high value range. Thus, it is possible to suppress the lowering of the output due to the temperature of the nickel-metal hydride battery **40** being low, and to realize stable charging/discharging. A discharge curve **133** shows the relationship between battery voltage and SOC when the nickel-metal hydride battery **40** is discharged from 90% SOC to 40% SOC. A charge curve **134** shows the relationship between battery voltage and SOC when the nickel-metal hydride battery **40** is charged from 40% SOC to 90% SOC.

Note that the lower limit of low temperature is the lower limit temperature at which the nickel-metal hydride battery **40** is usable, for example. For example, when the lower limit temperature at which the nickel-metal hydride battery **40** is usable is -20°C, the lower limit of low temperature is - 20°C.

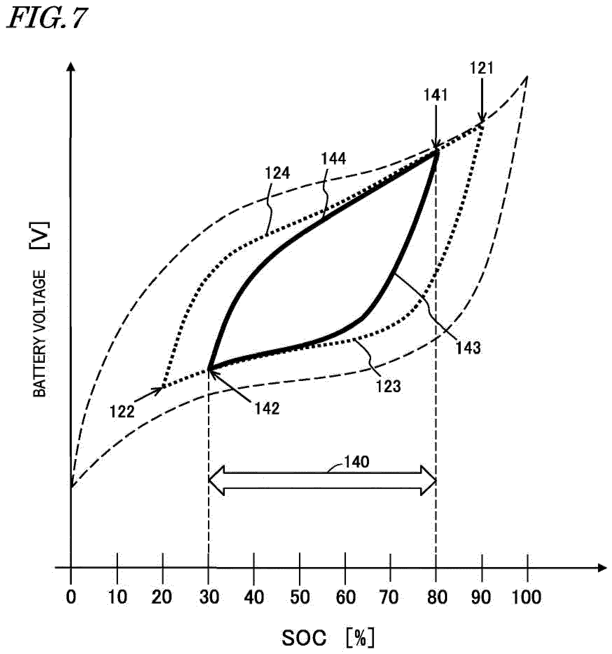

FIG. **7** shows an SOC use range **140** used when the temperature of the nickel-metal hydride battery **40** is a medium temperature. The vertical axis of FIG. **7** shows battery voltage and the horizontal axis thereof shows SOC. The nickel-metal hydride battery **40** being at a medium temperature means that the temperature of the nickel-metal hydride battery **40** is 10°C or more and less than 40°C, for example.

A lower limit **142** of the SOC use range **140** shown in FIG. **7** is lower than the lower limit **132** of the SOC use range **130** shown in FIG. **6****.** The upper limit **131** of the SOC use range **130** shown in FIG. **6** is higher than an upper limit **141** of the SOC use range **140** shown in FIG. **7****.**

In the example shown in FIG. **7****,** SOC is 80% at the upper limit **141** of the SOC use range **140** and 30% at the lower limit **142** thereof. When the temperature is a medium temperature, the microcontroller **61** controls the charging/discharging over the SOC use range **140.** A discharge curve **143** shows the relationship between battery voltage and SOC when the nickel-metal hydride battery **40** is discharged from 80% SOC to 30% SOC. A charge curve **144** shows the relationship between battery voltage and SOC when the nickel-metal hydride battery **40** is charged from 30% SOC to 80% SOC.

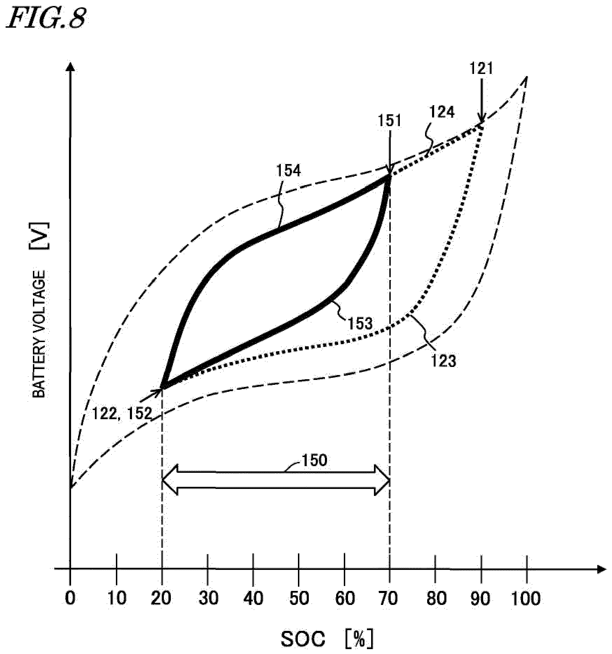

FIG. **8** shows an SOC use range **150** used when the temperature of the nickel-metal hydride battery **40** is a high temperature. The vertical axis of FIG. **8** shows battery voltage and the horizontal axis thereof shows SOC. The nickel-metal hydride battery **40** being at a high temperature means that the temperature of the nickel-metal hydride battery **40** is 40°C or more, for example.

A lower limit **152** of the SOC use range **150** shown in FIG. **8** is lower than the lower limit **142** of the SOC use range **140** shown in FIG. **7****.** The upper limit **141** of the SOC use range **140** shown in FIG. **7** is higher than an upper limit **151** of the SOC use range **150** shown in FIG. **8****.**

In the example shown in FIG. **8****,** SOC is 70% at the upper limit **151** of the SOC use range **150** and 20% at the lower SOC limit **152** thereof. The nickel-metal hydride battery **40** has a characteristic such that the charging efficiency lowers when the temperature is high. In other words, when the temperature is high, it is difficult to charge until the SOC reaches a high value. Therefore, when the temperature of the nickel-metal hydride battery **40** is high, the nickel-metal hydride battery **40** is charged/discharged over a use range such that SOC does not become too high. When the temperature is high, the microcontroller **61** controls the charging/discharging over the SOC use range **150,** which is a low value range. It is possible to realize stable charging/discharging by suppressing the lowering of the charging efficiency due to the temperature being high. A discharge curve **153** shows the relationship between battery voltage and SOC when the nickel-metal hydride battery **40** is discharged from 70% SOC to 20% SOC. A charge curve **154** shows the relationship between battery voltage and SOC when the nickel-metal hydride battery **40** is charged from 20% SOC to 70% SOC.

Note that the upper limit of high temperature is the upper limit temperature at which the nickel-metal hydride battery **40** is usable, for example. For example, when the upper limit temperature at which the nickel-metal hydride battery **40** is usable is 60°C, the upper limit of high temperature is 60°C.

The memory **62** (FIG. **4**) stores, in advance, information regarding a plurality of SOC use ranges having different SOC upper and lower limits as described above. The microcontroller **61** reads out information regarding SOC use ranges from the memory **62,** and sets a desired SOC use range.

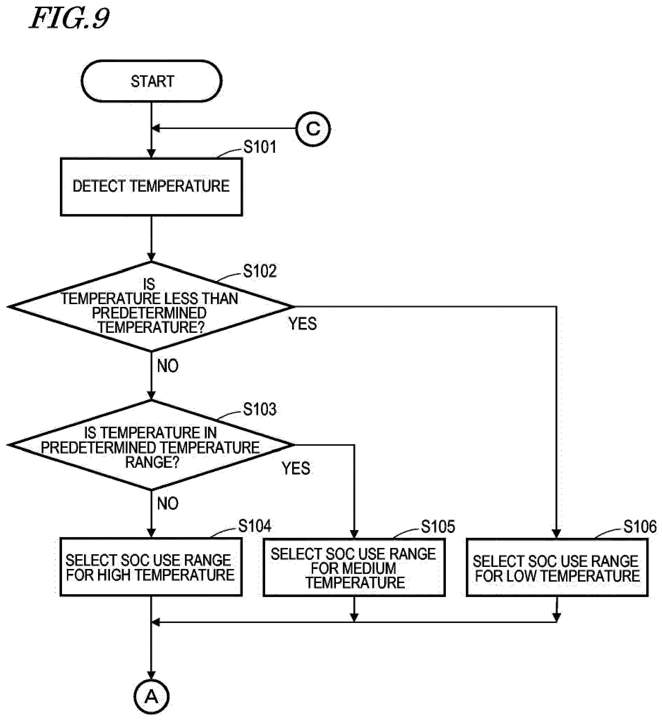

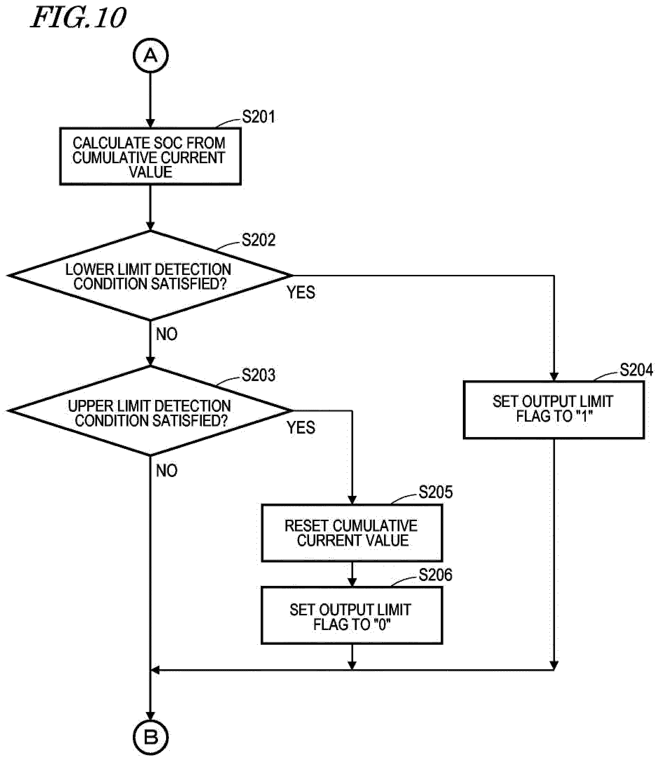

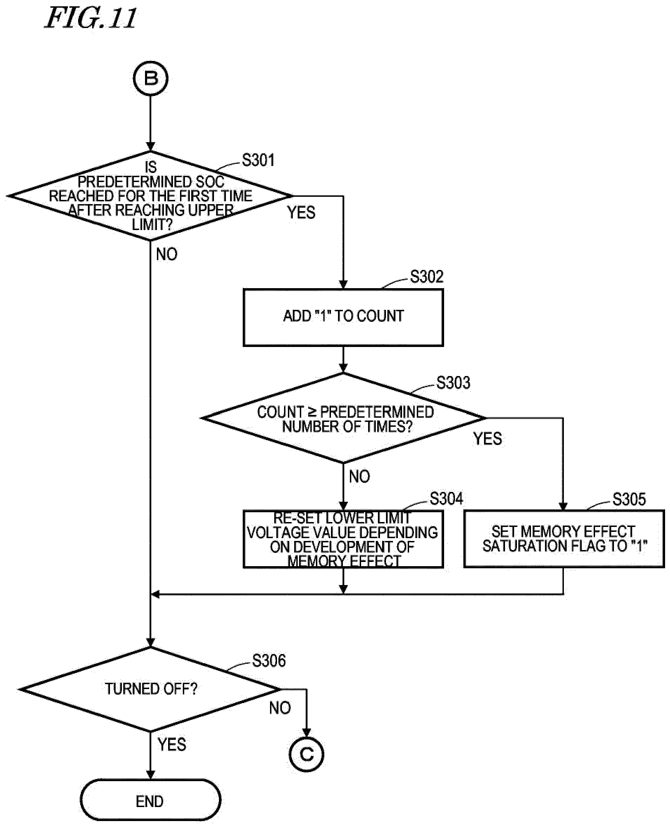

Using FIG. **9** to FIG. **11****,** a charging/discharging control of the nickel-metal hydride battery **40** will be described. FIG. **9** is a flow chart showing a control of changing the SOC use range depending on the temperature of the nickel-metal hydride battery **40.** FIG. **10** is a flow chart showing a charging/discharging control performed in accordance with the current SOC of the nickel-metal hydride battery **40.** FIG. **11** is a flow chart showing a charging/discharging control performed in conjunction with the memory effect of the nickel-metal hydride battery **40.**

First, using FIG. **9****,** a control of changing the SOC use range depending on the temperature of the nickel-metal hydride battery **40** will be described.

In step S101, the microcontroller **61** detects the temperature of the nickel-metal hydride battery **40** from the output signal of the temperature sensor **41.** In step S102, the microcontroller **61** determines whether the temperature of the nickel-metal hydride battery **40** is less than a predetermined temperature. The predetermined temperature is 10°C, for example. When it is determined that the temperature of the nickel-metal hydride battery **40** is less than the predetermined temperature, the microcontroller **61** selects the SOC use range **130** for low temperature (step S106). The microcontroller **61** controls the charging/discharging of the nickel-metal hydride battery **40** within the selected SOC use range **130.**

When it is determined in step S102 that the temperature of the nickel-metal hydride battery **40** is not less than the predetermined temperature, the process proceeds to step S103. In step S103, the microcontroller **61** determines whether the temperature of the nickel-metal hydride battery **40** is in the predetermined temperature range. The predetermined temperature range is 10°C or more and less than 40°C, for example. When it is determined that the temperature of the nickel-metal hydride battery **40** is in a predetermined temperature range, the microcontroller **61** selects the SOC use range **140** for medium temperature (step S105). The microcontroller **61** controls the charging/discharging of the nickel-metal hydride battery **40** within the selected SOC use range **140.**

When it is determined in step S103 that the temperature of the nickel-metal hydride battery **40** is not in the predetermined temperature range, the microcontroller **61** selects the SOC use range **150** for high temperature (step S104) . The microcontroller **61** controls the charging/discharging of the nickel-metal hydride battery **40** within the selected SOC use range **150.**

As described above, in the present embodiment, the process changes the SOC use range to be selected from among a plurality of SOC use ranges depending on the temperature of the nickel-metal hydride battery **40.**

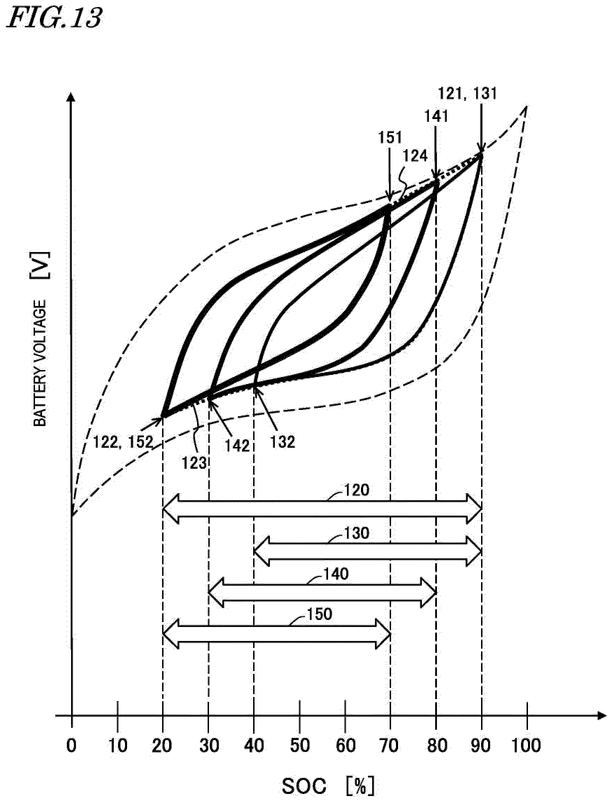

FIG. **13** shows the SOC use range **130** for low temperature, the SOC use range **140** for medium temperature and the SOC use range **150** for high temperature. The vertical axis of FIG. **13** shows battery voltage and the horizontal axis thereof shows SOC. By changing the SOC use range depending on the temperature of the nickel-metal hydride battery **40,** it is possible to charge/discharge over a wide SOC range. For example, it is possible to charge/discharge over a range from 20% to 90%, which corresponds to the wide SOC use range **120.** Being able to charge/discharge over a wide SOC range, it is possible to make effective use of the performance of the nickel-metal hydride battery **40.**

Now, a method for changing the SOC use range will be described. When the SOC use range is changed from the SOC use range **130** for low temperature to the SOC use range **140** for medium temperature, the microcontroller **61** performs a control of discharging the nickel-metal hydride battery **40** to the lower limit **142** of the SOC use range **140** for medium temperature. After reaching the lower limit **142,** the charging of the nickel-metal hydride battery **40** is started. Thus, it is possible to change the SOC use range from the SOC use range **130** for low temperature to the SOC use range **140** for medium temperature.

When the SOC use range is changed from the SOC use range **140** for medium temperature to the SOC use range **150** for high temperature, the microcontroller **61** performs a control of discharging the nickel-metal hydride battery **40** to the lower limit **152** of the SOC use range **150** for high temperature. After reaching the lower limit **152,** the charging of the nickel-metal hydride battery **40** is started. Thus, it is possible to change the SOC use range from the SOC use range **140** for medium temperature to the SOC use range **150** for high temperature.

Thus, when switching to a lower SOC use range, the nickel-metal hydride battery **40** is discharged to the lower limit of the target use range. Thus, it is possible to change the SOC use range.

Similarly, when the SOC use range is changed from the SOC use range **130** for low temperature to the SOC use range **150** for high temperature, the microcontroller **61** performs a control of discharging the nickel-metal hydride battery **40** to the lower limit **152** of the SOC use range **150** for high temperature. After reaching the lower limit **152,** the charging of the nickel-metal hydride battery **40** is started. Thus, it is possible to change the SOC use range from the SOC use range **130** for low temperature to the SOC use range **150** for high temperature.

When the SOC use range is changed from the SOC use range **150** for high temperature to the SOC use range **140** for medium temperature, the microcontroller **61** performs a control of charging the nickel-metal hydride battery **40** to the upper limit **141** of the SOC use range **140** for medium temperature. After reaching the upper limit **141,** the discharging of the nickel-metal hydride battery **40** is started. Thus, it is possible to change the SOC use range from the SOC use range **150** for high temperature to the SOC use range **140** for medium temperature.

When the SOC use range is changed from the SOC use range **140** for medium temperature to the SOC use range **130** for low temperature, the microcontroller **61** performs a control of charging the nickel-metal hydride battery **40** to the upper limit **131** of the SOC use range **130** for low temperature. After reaching the upper limit **131,** the discharging of the nickel-metal hydride battery **40** is started. Thus, it is possible to change the SOC use range from the SOC use range **140** for medium temperature to the SOC use range **130** for low temperature.

Thus, when switching to a higher SOC use range, the nickel-metal hydride battery **40** is charged to the upper limit of the target use range. Thus, it is possible to change the SOC use range.

Similarly, when the SOC use range is changed from the SOC use range **150** for high temperature to the SOC use range **130** for low temperature, the microcontroller **61** performs a control of charging the nickel-metal hydride battery **40** to the upper limit **131** of the SOC use range **130** for low temperature. After reaching the upper limit **131,** the discharging of the nickel-metal hydride battery **40** is started. Thus, it is possible to change the SOC use range from the SOC use range **150** for high temperature to the SOC use range **130** for low temperature.

Next, using FIG. **10****,** a charging/discharging control performed in accordance with the current SOC of the nickel-metal hydride battery **40** will be described.

The microcontroller **61** controls the charging/discharging of the nickel-metal hydride battery **40** in the SOC use range selected in step S104, S105, S106 of FIG. **9****.** Then, the microcontroller **61** calculates the current SOC of the nickel-metal hydride battery **40** by using the cumulative value of the current that is output from the nickel-metal hydride battery **40** (step S201). The use of the cumulative value of the current is mentioned as an example for calculating the current SOC of the nicke-metal hydride battery 40, but is not covered by the present invention, which requires the current SOC to be calculated from the battery voltage.

For example, when the SOC use range 130 is selected, the microcontroller **61** performs a control of charging the nickel-metal hydride battery **40** to the upper limit **131** of the SOC use range **130.** There may be an error between the SOC that is obtained by using the battery voltage and the charge curve while charging and the actual SOC. However, such an error can be reset at a point where the battery is charged to the upper limit of the selected SOC use range. This is because when the battery has been charged to the upper limit of the SOC use range, the precision of the relationship between voltage and SOC is high. It is possible to reduce the error in SOC by calculating the current SOC from the cumulative current value based on the SOC at the upper limit of the selected SOC use range.

When the nickel-metal hydride battery **40** is charged to the upper limit **131** of the SOC use range **130,** the microcontroller **61** causes the nickel-metal hydride battery **40** to output a current in accordance with the action of the motorcycle **100.** The microcontroller **61** detects the level of the current that is output from the nickel-metal hydride battery **40** based on the output signal of the current sensor **43.** The microcontroller **61** calculates the cumulative current value from the output current and the output duration. For example, the current SOC is obtained by subtracting the cumulative current value from SOC 90% at the upper limit **131** of the SOC use range **130.** By using the cumulative current value, it is possible to grasp the current SOC without using the voltage value of the nickel-metal hydride battery **40.**

In step S202, the microcontroller **61** determines whether the current SOC satisfies the lower limit detection condition of the selected SOC use range. The lower limit detection condition is a condition that the calculated current SOC is less than or equal to the lower limit value of the selected SOC use range. For example, where the SOC use range **130** is selected, the lower limit detection condition is a condition that the calculated current SOC is less than or equal to 40%, which is the level of the lower limit **132.** Satisfying the lower limit detection condition means that the current SOC has reached, or moved past, the lower limit of the selected SOC use range.

When it is determined that the lower limit detection condition is satisfied, the microcontroller **61** sets the output limit flag to "1" (step S204). When the output limit flag is "1", the microcontroller **61** controls the charging/discharging so that the amount of charging is greater than the amount of discharging.

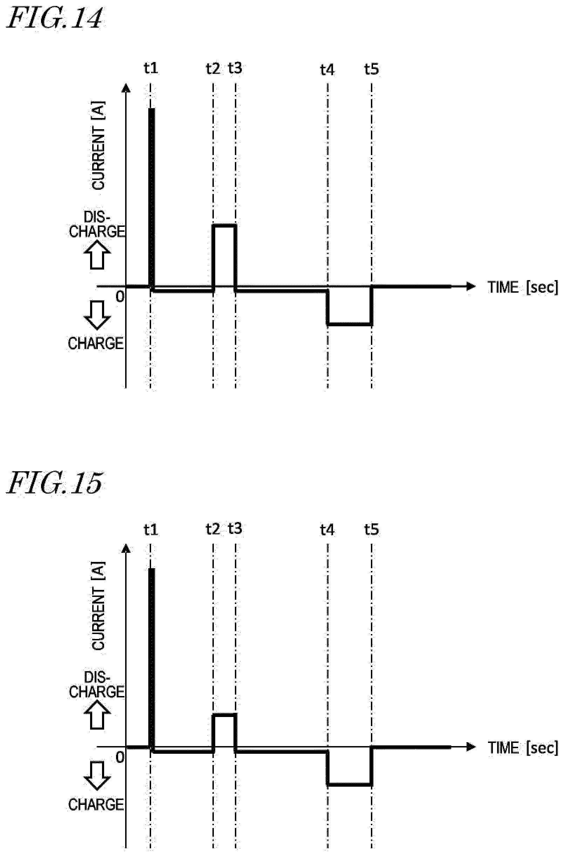

FIG. **14** shows an example of how the nickel-metal hydride battery **40** is charged/discharged where the lower limit detection condition is not satisfied. FIG. **15** shows how the nickel-metal hydride battery **40** is charged/discharged where the lower limit detection condition is satisfied. The vertical axis of FIG. **14** and FIG. **15** shows the current that is input/output to/from the nickel-metal hydride battery **40** and the horizontal axis thereof shows time.

Referring to FIG. **4** and FIG. **14****,** as the passenger turns ON the starter switch **52** at time t1, the microcontroller **61** conducts a large current flow through the rotating electrical machine **30** to operate the rotating electrical machine **30,** thereby starting the engine **20.** While the engine **20** is rotating through the combustion of fuel, the rotating electrical machine **30** can operate as a generator. As the rotating electrical machine **30** generates electric power, the nickel-metal hydride battery **40** is charged.

If the passenger performs an accelerator operation to demand a high output from time t2 to t3, the rotating electrical machine **30** operates as an assisting motor that assists the output of the engine **20.** Then, a current is supplied from the nickel-metal hydride battery **40** to the rotating electrical machine **30,** and the rotating electrical machine **30** generates an assist output.

If the passenger turns OFF the accelerator operation or performs a braking operation from time t4 to t5, the rotating electrical machine **30** generates regeneration energy, and the nickel-metal hydride battery **40** is charged.

FIG. **15** shows how the nickel-metal hydride battery **40** is charged/discharged where the lower limit detection condition is satisfied. Where the lower limit detection condition is satisfied, the microcontroller **61** controls the charging/discharging so that the amount of charging is greater than the amount of discharging. For example, from time t2 to t3, when the rotating electrical machine **30** generates an assist output, the current to be output from the nickel-metal hydride battery **40** is lowered, thereby suppressing the amount of discharging. It is possible to further charge the nickel-metal hydride battery **40** by keeping the amount of charging greater than the amount of discharging.

When it is determined in step S202 of FIG. **10** that the lower limit detection condition is not satisfied, the microcontroller **61** determines whether the current SOC satisfies the upper limit detection condition of the selected SOC use range (step S203).

The upper limit detection condition is a condition that the calculated current SOC is greater than or equal to the upper limit value of the selected SOC use range. For example, where the SOC use range **130** is selected, the upper limit detection condition is a condition that the calculated current SOC is greater than or equal to 90%, which is the level of the upper limit **131.** Satisfying the upper limit detection condition means that the current SOC has reached, or moved past, the upper limit of the selected SOC use range.

When it is determined that the upper limit detection condition is satisfied, the microcontroller **61** resets the cumulative current value and sets the output limit flag to "0" (steps S205 and S206). It is possible to newly calculate the current SOC from the cumulative current value based on the SOC at the upper limit of the selected SOC use range. When the output limit flag is "0", the current output limitation as illustrated in FIG. **15** is not performed.

When it is determined in step S203 that the upper limit detection condition is not satisfied, the process proceeds to step S301 shown in FIG. **11****.** Similarly, after steps S204 and S206 are performed, the process proceeds to step S301 shown in FIG. **11****.**

Note that while the lower limit detection condition is a condition that the calculated current SOC is less than or equal to the lower limit value of the selected SOC use range in the example described above, the lower limit detection condition is not limited thereto. For example, the lower limit detection condition may be a condition that the current battery voltage obtained from the output signal of the voltage sensor **42** is less than or equal to a voltage that corresponds to the lower limit SOC of the selected SOC use range. The voltage corresponding to the lower limit SOC is a voltage that is identified based on the relationship between the discharge curve and the level of the lower limit SOC. When the lower limit detection condition is satisfied, it is assumed that the current SOC has reached, or moved past, the lower limit of the selected SOC use range. When it is determined that the lower limit detection condition is satisfied, the microcontroller **61** sets the output limit flag to "1" and controls the charging/discharging so that the amount of charging is greater than the amount of discharging.

While the upper limit detection condition is a condition that the calculated current SOC is greater than or equal to the upper limit value of the selected SOC use range in the example described above, the upper limit detection condition is not limited thereto. For example, the upper limit detection condition may be a condition that the current battery voltage is greater than or equal to a voltage that corresponds to the upper limit SOC of the selected SOC use range. The voltage corresponding to the upper limit SOC is a voltage that is identified based on the relationship between the charge curve and the level of the upper limit SOC. When the upper limit detection condition is satisfied, it is assumed that the current SOC has reached, or moved past, the upper limit of the selected SOC use range. When it is determined that the upper limit detection condition is satisfied, the microcontroller **61** resets the cumulative current value and sets the output limit flag to "0".

While the operation where the SOC use range **130** is selected is illustrated in the description of FIG. **10** above, it similarly applies also to the operation where the SOC use range **140** or **150** is selected.

Next, a charging/discharging control performed in conjunction with the memory effect of the nickel-metal hydride battery **40** will be described.

Now, a problem that arises when a plurality of SOC use ranges are selectively used will be described. As described above, by selectively using a plurality of SOC use ranges depending on the condition of use according to a temperature of the nickel-metal hydride battery **40,** it is possible to charge/discharge over a wide SOC range. On the other hand, the discharge curves **133, 143** and **153** of the SOC use ranges **130, 140** and **150** are different from each other. Therefore, in embodiments where a plurality of SOC use ranges are selectively used, it is difficult to precisely detect the memory effect.

In the present embodiment, a predetermined SOC is defined as an SOC of a particular level that is included in all of the SOC use ranges **130, 140** and **150.** Then, information regarding the memory effect is obtained at a point in time when the SOC of the nickel-metal hydride battery **40** becomes equal to the predetermined SOC. Thus, it is possible to precisely detect the memory effect.

In the present embodiment, the predetermined SOC is an SOC that corresponds to the lower limit of the SOC use range **130,** e.g., 40%. SOC 40% is an SOC of a level that is included in all of the SOC use ranges **130, 140** and **150.** Therefore, irrespective of which one of the SOC use ranges **130, 140** and **150** is selected, there exists a point in time at which the SOC of the nickel-metal hydride battery **40** becomes equal to the predetermined SOC as the SOC transitions. As will be described below, information regarding the memory effect is obtained at a point in time at which the current SOC of the nickel-metal hydride battery **40** becomes equal to the predetermined SOC.

While the predetermined SOC is 40% in the description therein, the predetermined SOC is not limited thereto. The predetermined SOC may be of any level that is included in all of the SOC use ranges **130, 140** and **150,** and it is not limited to the level of the lower limit of the use range **130.** For example, the predetermined SOC may be any value that is 40% or more and less than 50%. The memory effect is likely to occur particularly in the region where SOC is less than 50% as compared with the region where SOC is 50% or more. As the region where information regarding the memory effect is obtained is set to the region where SOC is less than 50%, it is possible to perform a more appropriate control.

In step S301 of FIG. **11****,** the microcontroller **61** determines whether the SOC of the nickel-metal hydride battery **40** has become equal to the predetermined SOC for the first time after reaching the upper limit of the selected SOC use range.

When it is determined that the current SOC of the nickel-metal hydride battery **40** is equal to the predetermined SOC, the microcontroller **61** obtains information regarding the memory effect of the nickel-metal hydride battery **40.** In the example shown in FIG. **11****,** the microcontroller **61** adds "1" to the count, and obtains the total count as information regarding the memory effect (step S302).

In step S303, the microcontroller **61** determines whether the count is greater than or equal to a predetermined number of times. While the predetermined number of times is 30, for example, it is not limited thereto. When it is determined that the count is greater than or equal to the predetermined number of times, the microcontroller **61** sets the memory effect saturation flag to "1" (step S305). When the memory effect saturation flag is "1", the microcontroller **61** may perform a control of refreshing the nickel-metal hydride battery **40** as will be described below.

As the nickel-metal hydride battery **40** is repeatedly charged/discharged, the memory effect develops, thereby decreasing the voltage that is obtained while discharging. When the count becomes greater than or equal to the predetermined number of times, it is possible to restore the voltage that is obtained while discharging by refreshing the nickel-metal hydride battery **40,** for example.

By counting the number of times at a predetermined SOC that is included in all of the SOC use ranges **130, 140** and **150,** it is possible to precisely count the number of times without failing to count the number of times irrespective of which one of the SOC use ranges **130, 140** and **150** is selected.

When it is determined in step S303 that the count is not greater than or equal to the predetermined number of times, the process proceeds to step S304. In step S304, the microcontroller **61** re-sets the voltage at the lower limit of each of the SOC use ranges **130, 140** and **150** depending on the development of the memory effect.

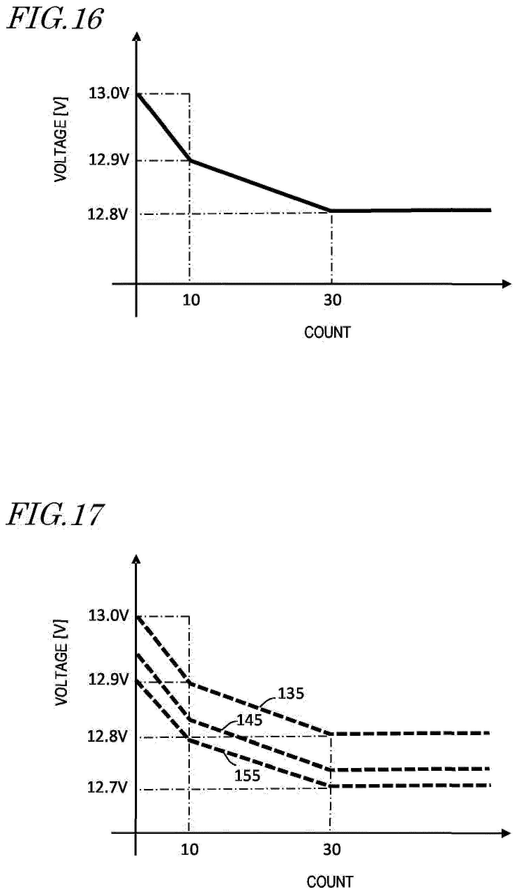

FIG. **16** shows how the memory effect develops. The vertical axis of FIG. **16** shows battery voltage, and the horizontal axis thereof shows count. When the nickel-metal hydride battery **40** is repeatedly charged/discharged, the battery voltage at the lower limit of the SOC use range lowers gradually. Then, the memory effect saturates when the count reaches 30, for example.

FIG. **17** shows a control of lowering the lower limit voltages of the respective discharge curves **133, 143** and **153** of the SOC use ranges **130, 140** and **150** depending on the count. The vertical axis of FIG. **17** shows battery voltage, and the horizontal axis thereof shows count. The broken line **135** denotes the lower limit voltage of the discharge curve **133** of the SOC use range **130.** The broken line **145** denotes the lower limit voltage of the discharge curve **143** of the SOC use range **140.** The broken line **155** denotes the lower limit voltage of the discharge curve **153** of the SOC use range **150.**

As shown in FIG. **17****,** the lower limit voltages of the respective discharge curves **133, 143** and **153** of the SOC use ranges **130, 140** and **150** depending on the count. In all possible embodiments covered by the present invention the current SOC is calculated from the battery voltage; therefore, if a voltage drop occurs due to the memory effect, it may be determined that the current SOC of the nickel-metal hydride battery has reached the lower limit even though the actual SOC use range has not reached the lower limit. The lower limit voltage of the discharge curve is lowered depending on the degree of voltage drop due to the memory effect. Thus, it is possible to suppress narrowing of the SOC range that is actually used even if the memory effect develops.

While the power supply of the vehicle is ON (NO in step S306), the process returns to step S101 shown in FIG. **9****,** continuing the detection of the temperature. When there is no change to the temperature range of the nickel-metal hydride battery **40,** the currently-selected SOC use range is maintained. In step S102 or S103, if there is a change to the temperature range, the SOC use range is changed to an SOC use range depending on the latest temperature. For example, when the temperature of the nickel-metal hydride battery **40** changes to 10°C or more and less than 40°C during a control using the SOC use range **130** for low temperature, the microcontroller **61** changes from the SOC use range **130** for low temperature to the SOC use range **140** for medium temperature. For example, when the temperature of the nickel-metal hydride battery **40** changes to 40°C or more during a control using the SOC use range **140** for medium temperature, the microcontroller **61** changes from the SOC use range **140** for medium temperature to the SOC use range **150** for high temperature.

The process ends when the power supply of the vehicle is turned OFF (YES in step S306).

Although a control regarding the memory effect is performed depending on the number of times the SOC of the nickel-metal hydride battery **40** becomes equal to the predetermined SOC in the description above, a control regarding the memory effect may be performed depending on the battery voltage at a point in time when the SOC of the nickel-metal hydride battery **40** becomes equal to the predetermined SOC.

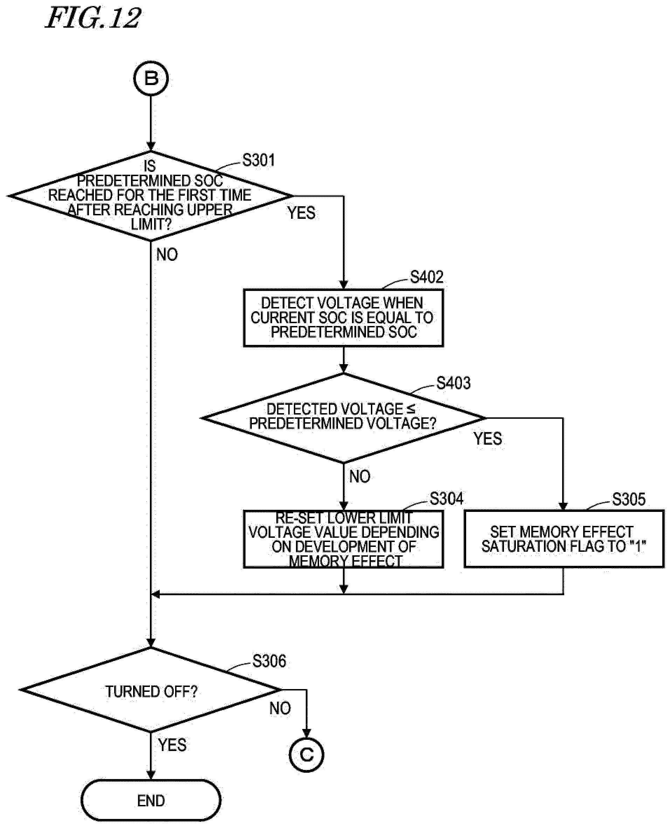

FIG. **12** is a flow chart showing a control regarding the memory effect performed depending on the battery voltage. Steps S301, S304, S305 and S306 shown in FIG. **12** are similar to those steps shown in FIG. **11****.**

When it is determined in step S301 shown in FIG. **12** that the current SOC of the nickel-metal hydride battery **40** is equal to the predetermined SOC, the microcontroller **61** obtains information regarding the memory effect of the nickel-metal hydride battery **40.** In the example shown in FIG. **12****,** the microcontroller **61** detects, from the output signal of the voltage sensor **42,** the battery voltage at a point in time when the current SOC is equal to the predetermined SOC, and obtains information regarding the memory effect (step S402).

As shown in FIG. **13****,** at the predetermined SOC that corresponds to the lower limit of the SOC use range **130,** the difference is small between the voltage along the discharge curve of the SOC use range **130,** the voltage along the discharge curve of the SOC use range **140** and the voltage along the discharge curve of the SOC use range **150.** The voltage of the nickel-metal hydride battery **40** at a point in time when the SOC becomes equal to the predetermined SOC, at which the voltage difference is small, is detected. By using the voltage value that is detected in the region where the voltage difference is small between the SOC use ranges **130, 140** and **150,** it is possible to precisely detect the voltage drop due to the memory effect.

In step S403, the microcontroller **61** determines whether the detected battery voltage is less than or equal to a predetermined voltage. While the predetermined voltage is 12.8 V, for example, the predetermined voltage is not limited thereto. When it is determined that the detected battery voltage is less than or equal to the predetermined voltage, the microcontroller **61** sets the memory effect saturation flag to "1" (step S305). When the memory effect saturation flag is "1", the microcontroller **61** may perform a control of refreshing the nickel-metal hydride battery **40** as will be described below.

By using the voltage value that is detected in the region where the voltage difference is small between the SOC use ranges **130, 140** and **150,** it is possible to precisely detect the voltage drop due to the memory effect. By precisely detecting the voltage drop due to the memory effect, it is possible to refresh the nickel-metal hydride battery **40** with appropriate timing.

When it is determined in step S403 that the detected battery voltage is not less than or equal to the predetermined voltage, the process proceeds to step S304. In step S304, the microcontroller **61** re-sets the voltage at the lower limit of each of the SOC use ranges **130, 140** and **150** depending on the development of the memory effect.

Re-setting of the lower limit voltage may be performed depending on the count as described above using FIG. **17****,** or may be performed depending on the degree of battery voltage drop at a point in time when the SOC of the nickel-metal hydride battery **40** becomes equal to the predetermined SOC. The lower limit of the voltage of the discharge curve is lowered depending on the voltage drop due to the memory effect. Thus, it is possible to suppress narrowing of the SOC range that is actually used even if the memory effect develops.

Note that the microcontroller **61** may correct the value of the battery voltage that is detected at a point in time when the current SOC is equal to the predetermined SOC, in accordance with the currently-selected SOC use range of the SOC use ranges **130, 140** and **150.**

The voltage value at the predetermined SOC somewhat varies between different SOC use ranges. By correcting the voltage value in accordance with the currently-selected SOC use range, it is possible to more precisely detect the voltage drop due to the memory effect.

For example, assume that it is known in advance that the difference between the voltage at the predetermined SOC of the SOC use range **130** and the voltage at the predetermined SOC of the SOC use range **150** is about 0.2 V. In such a case, a value obtained by subtracting 0.2 V from the voltage at the predetermined SOC that is detected while the SOC use range **150** is selected is obtained as the information regarding the memory effect. Then, in step S403, the corrected value and the predetermined voltage are compared with each other. Thus, it is possible to more precisely detect the voltage drop due to the memory effect.

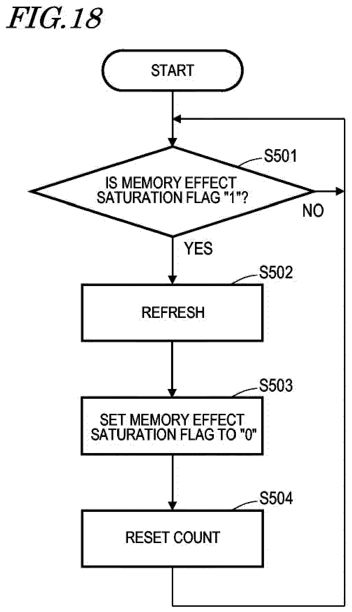

Next, a control of refreshing the nickel-metal hydride battery **40** will be described. FIG. **18** is a flow chart showing a control of refreshing the nickel-metal hydride battery **40.** As described above, when the memory effect saturation flag is "1", the microcontroller **61** may perform a control of refreshing the nickel-metal hydride battery **40.**

In step S501, the microcontroller **61** determines whether the memory effect saturation flag is "1". When it is determined that the memory effect saturation flag is not "1", the determination is periodically repeated until the memory effect saturation flag becomes "1".

When it is determined that the memory effect saturation flag is "1", the microcontroller **61** refreshes the nickel-metal hydride battery **40** (step S502). In the refresh operation, the nickel-metal hydride battery **40** is discharged until the voltage of the nickel-metal hydride battery **40** reaches the discharge termination voltage, for example. After the voltage of the nickel-metal hydride battery **40** reaches the discharge termination voltage, the nickel-metal hydride battery **40** is charged to the upper limit **131** of the SOC use range **130.** Thus, it is possible to restore the battery voltage that is obtained while discharging.

After refreshing the nickel-metal hydride battery **40,** the microcontroller **61** sets the memory effect saturation flag to "0" (step S503). The number of times that is counted in step S302 (FIG. **11**) is reset (step S504). Then, referring back to step S501, the determination is periodically repeated until the memory effect saturation flag becomes "1" the next time.

In the present embodiment, it is possible to precisely detect the degree of development of the memory effect. By precisely detecting the degree of development of the memory effect, it is possible to refresh the nickel-metal hydride battery **40** with appropriate timing.

Next, the process when the nickel-metal hydride battery **40** is initially discharged will be described. The initial discharge of the nickel-metal hydride battery **40** is, for example, the first discharge after shipping of the nickel-metal hydride battery **40.**

FIG. **13** shows a charging/discharging characteristic after the elapse of a certain period of time or longer since the start of use of the nickel-metal hydride battery **40** after shipping. For example, it shows a charging/discharging characteristic that is obtained after repeating a control of changing the SOC use range depending on the temperature. In the example shown in FIG. **13****,** the relationship between battery voltage and SOC at the lower limit **152** of the SOC use range **150** is along the discharge curve **123.** The relationship between battery voltage and SOC at the lower limit **142** of the SOC use range **140** is along the discharge curve **123.** The relationship between battery voltage and SOC at the upper limit **151** of the SOC use range **150** is along the charge curve **124.** The relationship between battery voltage and SOC at the upper limit **141** of the SOC use range **140** is along the charge curve **124.**

The discharge curve **123** is a discharge curve that is obtained by discharging from the upper limit **131** of the SOC use range **130** to the lower limit **152** of the SOC use range **150.** The charge curve **124** is a charge curve that is obtained by charging from the lower limit **152** of the SOC use range **150** to the upper limit **131** of the SOC use range **130.** By discharging to the lower limit **152** of the SOC use range **150** and charging to the upper limit **131** of the SOC use range **130,** the discharge curve **123** and the charge curve **124** (a discharge curve and a charge curve that are to be the reference) are obtained that connect together the upper limit **131** of the SOC use range **130** and the lower limit **152** of the SOC use range **150.**

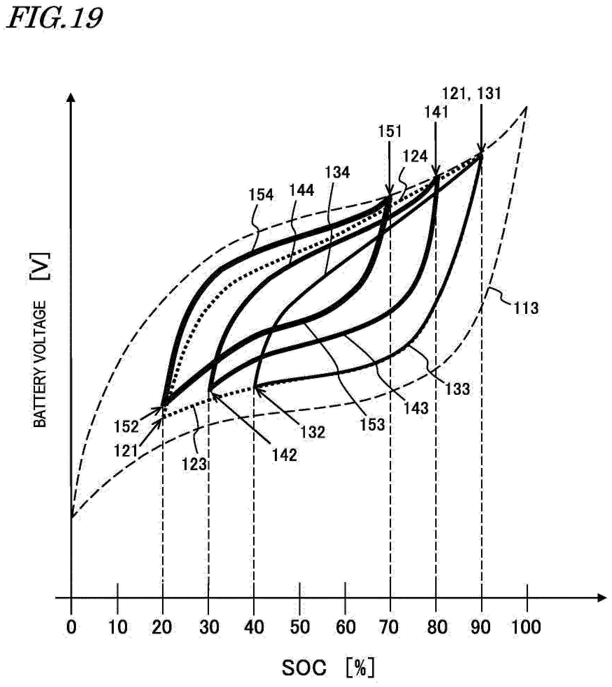

FIG. **19** shows a charging/discharging characteristic when a period has not elapsed since the first use of the nickel-metal hydride battery **40** after shipping. The vertical axis of FIG. **19** shows battery voltage, and the horizontal axis thereof shows SOC.

In the example shown in FIG. **19****,** the relationship between battery voltage and SOC at the lower limit **152** of the SOC use range **150** is apart from the discharge curve **123.** The relationship between battery voltage and SOC at the lower limit **142** of the SOC use range **140** is apart from the discharge curve **123.** The relationship between battery voltage and SOC at the upper limit **151** of the SOC use range **150** is apart from the charge curve **124.** The relationship between battery voltage and SOC at the upper limit **141** of the SOC use range **140** is apart from the charge curve **124.** In the process of repeating a control of changing the SOC use range depending on the temperature, the discharge curves **143** and **153** and the charge curves **144** and **154** of the SOC use ranges **140** and **150** move.

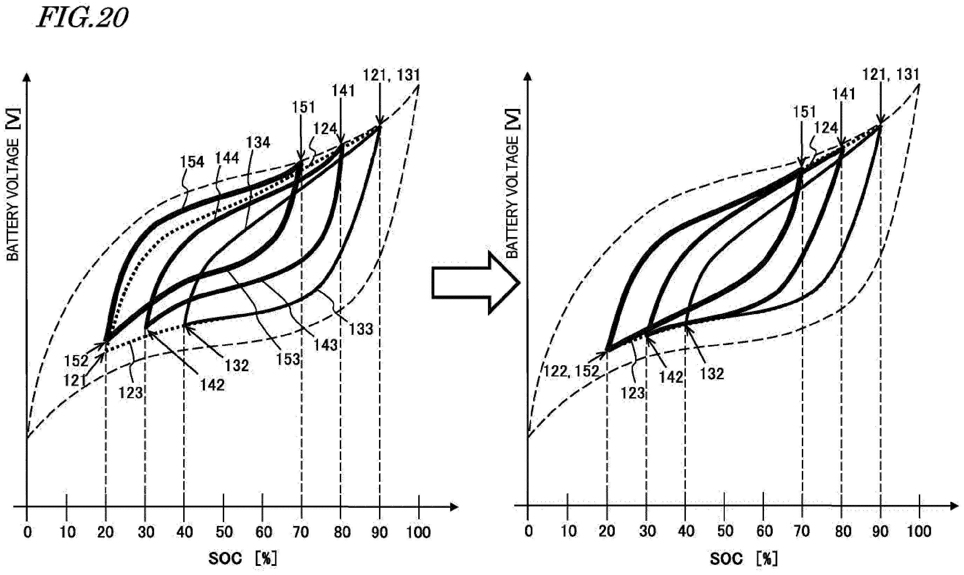

FIG. **20** shows how the discharge curves **143** and **153** and the charge curves **144** and **154** move. The graph on the left side of FIG. **20** shows a charging/discharging characteristic of the nickel-metal hydride battery **40** immediately after shipping. The graph on the right side of FIG. **20** shows a charging/discharging characteristic after the discharge curves **143** and **153** and the charge curves **144** and **154** have moved. The vertical axis of FIG. **20** shows battery voltage, and the horizontal axis thereof shows SOC.

As shown in FIG. **20****,** the nickel-metal hydride battery **40** exhibits a different charging/discharging characteristic depending on the status of charge. For example, the nickel-metal hydride battery **40** that has been charged to the upper limit **151** of the SOC use range **150** has the discharge curve **153** and the charge curve **154** that are based on the upper limit **151.** For example, the nickel-metal hydride battery **40** that has been charged to the upper limit **141** of the SOC use range **140** has the discharge curve **143** and the charge curve **144** that are based on the upper limit **141.** In the process of repeating a control of changing the SOC use range depending on the temperature, the discharge curves **143** and **153** and the charge curves **144** and **154** move closer to the discharge curve **123** and the charge curve **124** that are based on the upper limit **131.** If the discharge curves **143** and **153** move during use as described above, it is difficult to precisely detect the memory effect.

In view of this, in the present embodiment, the nickel-metal hydride battery **40** is charged to the upper limit **131** of the SOC use range **130** at the time of initial charging/discharging. The upper limit **131** is of the same level as the upper limit **121.** If the nickel-metal hydride battery **40** is self-discharging at the time of initial charging/discharging, the nickel-metal hydride battery **40** is charged to the upper limit **131** of the SOC use range **130** at the time of initial charging/discharging. After the nickel-metal hydride battery **40** is charged to the upper limit **131,** the nickel-metal hydride battery **40** is discharged to the lower limit of the SOC use range depending on the temperature condition. After being discharged to the lower limit of the SOC use range, it is charged to the upper limit of the SOC use range depending on the temperature condition. Thus, the discharge curves **143** and **153** can be made to extend along the discharge curve **123** to be the reference. After the discharge curves **143** and **153** are made to extend along the discharge curve **123** to be the reference, the discharge curves **143** and **153** no longer move except by the influence of the memory effect. As the discharge curves **143** and **153** no longer move except by the influence of the memory effect, it is possible to precisely detect the memory effect.

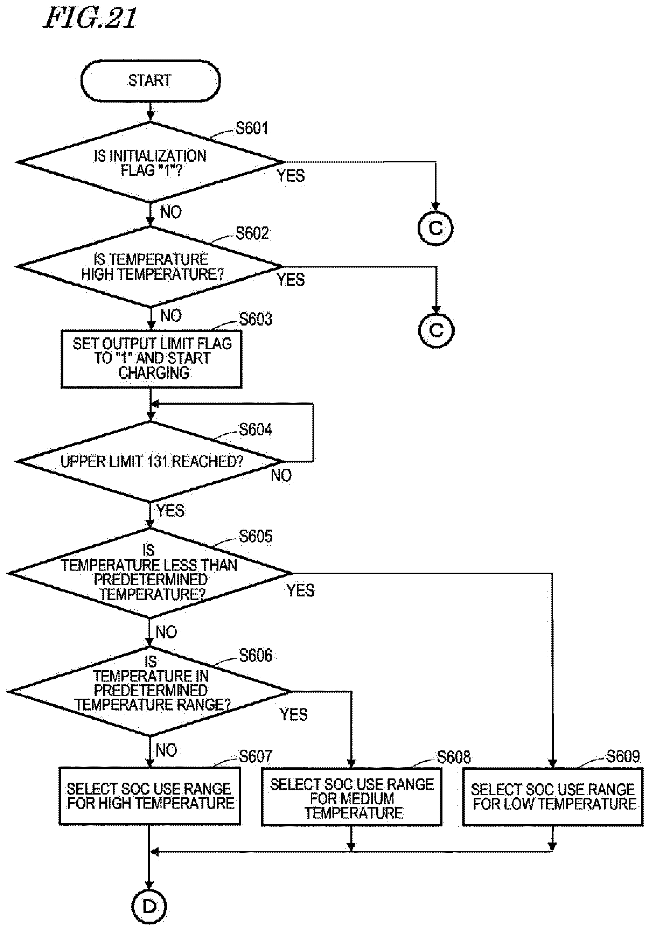

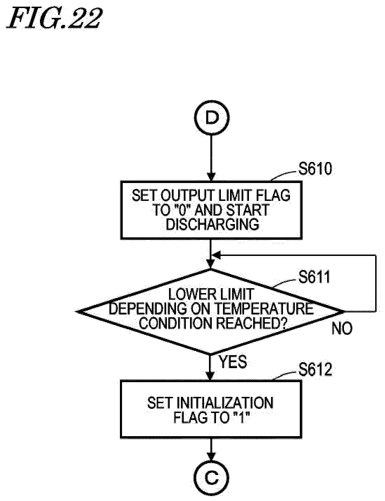

FIG. **21** and FIG. **22** are flow charts showing an initial charge/discharge control of the nickel-metal hydride battery **40.**

In step S601, the microcontroller **61** determines whether the initialization flag is "1". The initialization flag is stored in the memory **62,** for example. Where the process shown in steps S603 to S612 to be described below has not been performed, the initialization flag represents "0". Where the process shown in steps S603 to S612 has been completed, the initialization flag represents "1".

When it is determined that the initialization flag is "1", the microcontroller **61** executes the process of changing the SOC use range depending on the temperature shown in FIG. **9****.**

When it is determined that the initialization flag is not "1", the microcontroller **61** determines whether the temperature of the nickel-metal hydride battery **40** is a high temperature (step S602). As described above, the nickel-metal hydride battery **40** being at a high temperature means that the temperature of the nickel-metal hydride battery **40** is at 40°C or more, for example.

When it is determined that the nickel-metal hydride battery **40** is at a high temperature, the microcontroller **61** executes the process of changing the SOC use range depending on the temperature shown in FIG. **9****.** When the temperature of the nickel-metal hydride battery **40** is high, it is difficult to charge the nickel-metal hydride battery **40** to a high value such as SOC 90%. Therefore, when the nickel-metal hydride battery **40** is at a high temperature, the process shown in steps S603 to S612 is not performed. When the motorcycle **100** is started the next time, the determination of step S601 is performed again. While the operating environment of the motorcycle **100** continues to be a high temperature, the process shown in steps S603 to S612 is not performed. However, while a high-temperature operating environment continues, a control of selectively using a plurality of SOC use ranges is not performed, and there is no need to perform charging/discharging as shown in steps S603 to S612.

When it is determined that the nickel-metal hydride battery **40** is not at a high temperature, the microcontroller **61** sets the output limit flag to "1" and starts charging the nickel-metal hydride battery **40** (step S603). The output limit flag is set to "1", and a control is performed so that the amount of charging is greater than the amount of discharging. Discharging is kept to the minimum necessary, e.g., limited to discharging at the start-up of the engine **20.**

The microcontroller **61** continues to charge the nickel-metal hydride battery **40** until the upper limit **131** of the SOC use range **130** is reached (step S604).

When it is determined that the nickel-metal hydride battery **40** has been charged to reach the upper limit **131** of the SOC use range **130,** the microcontroller **61** starts discharging the nickel-metal hydride battery **40.** As will be described below, the microcontroller **61** continues to discharge the nickel-metal hydride battery **40** until the lower limit of the SOC use range depending on the temperature condition is reached. Discharging is kept to the minimum necessary, e.g., limited only to the regenerative operation while decelerating and stopping.

In step S605, the microcontroller **61** determines whether the temperature of the nickel-metal hydride battery **40** is less than a predetermined temperature. The predetermined temperature is 10°C, for example. When it is determined that the temperature of the nickel-metal hydride battery **40** is less than a predetermined temperature, the microcontroller **61** selects the SOC use range **130** for low temperature (step S609). The microcontroller **61** starts discharging the nickel-metal hydride battery **40** within the selected SOC use range **130** (step S610). At the same time, in step S610, the output limit flag is set to "0".

When it is determined in step S605 that the temperature of the nickel-metal hydride battery **40** is not less than a predetermined temperature, the process proceeds to step S606. In step S606, the microcontroller **61** determines whether the temperature of the nickel-metal hydride battery **40** is in a predetermined temperature range. The predetermined temperature range is 10°C or more and less than 40°C, for example. When it is determined that the temperature of the nickel-metal hydride battery **40** is in the predetermined temperature range, the microcontroller **61** selects the SOC use range **140** for medium temperature (step S608). The microcontroller **61** starts discharging the nickel-metal hydride battery **40** within the selected SOC use range **140** (step S610).

When it is determined in step S606 that the temperature of the nickel-metal hydride battery **40** is not in the predetermined temperature range, the microcontroller **61** selects the SOC use range **150** for high temperature (step S607) . The microcontroller **61** starts discharging the nickel-metal hydride battery **40** within the selected SOC use range **150** (step S610) .

The microcontroller **61** continues to discharge the nickel-metal hydride battery **40** until the lower limit of the selected SOC use range is reached (step S611) . After it is determined in step S611 that the lower limit of the SOC use range depending on the temperature condition is reached, the initialization flag is set to "1" (step S612). Then, the process proceeds to steps S101 to S106 of FIG. **9****,** and steps S201 to S206 of FIG. **10****.** Since the nickel-metal hydride battery **40** is discharged to the lower limit of the SOC use range depending on the temperature condition, the output limit flag is always "1" in step S202, and a control is performed so that the amount of charging is greater than the amount of discharging. At this point, the charge curves **144** and **154** change so as to conform to the charge curve **124.**

Then, when the nickel-metal hydride battery **40** is charged to reach the upper limit **141** of the SOC use range **140,** the output limit flag is set to "0", and a control is performed so that the amount of discharging is greater than the amount of charging. At this point, the discharge curve **143** changes so as to conform to the discharge curve **123.** Also when the nickel-metal hydride battery **40** is charged to reach the upper limit **151** of the SOC use range **150,** the discharge curve **153** changes so as to conform to the discharge curve **123.**

Thus, immediately after starting to use the nickel-metal hydride battery **40,** the discharge curves **143** and **153** can be made to conform to the discharge curve **123.** After performing such initial charging/discharging, the control regarding the memory effect described above is executed. As the discharge curves **143** and **153** do not move except by the influence of the memory effect, it is possible to precisely detect the memory effect.

While the initial discharge of the nickel-metal hydride battery **40** is the first discharge after shipping of the nickel-metal hydride battery **40** in the example described above, the initial discharge may be the first discharge after supplemental charging of the nickel-metal hydride battery **40.** Immediately after starting to use the nickel-metal hydride battery **40** after replenishing charging, the discharge curves **143** and **153** can be made to conform to the discharge curve **123.** As the discharge curves **143** and **153** do not move except by the influence of the memory effect, it is possible to precisely detect the memory effect even after replenishing charging.

Three SOC use ranges are selectively used depending on the temperature in the description above. Alternatively, the number of SOC use ranges to be selectively used depending on the temperature may be two or may be four or more.

An illustrative embodiment has been described above.

A battery control system **6** according to an embodiment controls the charging/discharging of the nickel-metal hydride battery **40** having a hysteresis characteristic for the relationship between voltage and SOC (State Of Charge). The battery control system **6** includes the memory **62** (storage medium) for storing information regarding the SOC use ranges **130, 140** and **150** having different SOC upper and lower limits, and the microcontroller **61** (control circuit) for selecting one of the SOC use ranges **130, 140** and **150** depending on the condition of use of the nickel-metal hydride battery **40** and performing a charge/discharge control of the nickel-metal hydride battery **40** in accordance with the selected SOC use range. The SOC use ranges include the first use range **130,** and the second use ranges **140** and **150** each including an SOC of the same level as the SOC lower limit **132** of the first use range **130.** The microcontroller **61** determines whether the current SOC of the nickel-metal hydride battery **40** is equal to a predetermined SOC that corresponds to the SOC lower limit **132** of the first use range **130.** When it is determined that the current SOC of the nickel-metal hydride battery **40** is equal to the predetermined SOC, the microcontroller **61** obtains information regarding the memory effect of the nickel-metal hydride battery **40** and controls the discharge of the nickel-metal hydride battery **40** using the obtained information regarding the memory effect.

By selectively using the SOC use ranges **130, 140** and **150** depending on the condition of use of the nickel-metal hydride battery **40,** it is possible to charge/discharge over a wide SOC range. Being able to charge/discharge over a wide SOC range, it is possible to make effective use of the performance of the nickel-metal hydride battery **40.**

On the other hand, the discharge curves of the SOC use ranges **130, 140** and **150** are different from each other. Therefore, in embodiments where the SOC use ranges **130, 140** and **150** are selectively used, it is difficult to precisely detect the memory effect.

In the embodiment, a predetermined SOC that corresponds to the SOC lower limit **132** of the first use range **130** is included in all of the first and second use ranges **130, 140** and **150.** Irrespective of which one of the first and second use ranges **130, 140** and **150** is selected, there exists a point in time at which the SOC of the nickel-metal hydride battery **40** becomes equal to the predetermined SOC as the SOC transitions. When it is determined that the current SOC of the nickel-metal hydride battery **40** is equal to the predetermined SOC, information regarding the memory effect is obtained. Then, it is possible to precisely detect the memory effect.

For example, at the predetermined SOC that corresponds to the SOC lower limit **132** of the first use range **130,** the difference is small between the voltage along the discharge curve of the first use range **130** and the voltage along the discharge curve of the second use ranges **140** and **150.** The voltage of the nickel-metal hydride battery **40** at a point in time when the SOC becomes equal to the predetermined SOC, at which the voltage difference is small, is detected. By using the voltage value that is detected in the region where the voltage difference is small between the SOC use ranges **130, 140** and **150,** it is possible to precisely detect the voltage drop due to the memory effect. By precisely detecting the voltage drop due to the memory effect, it becomes easy to repeat the charging/discharging in the selected SOC use range, and it is also possible to refresh the nickel-metal hydride battery **40** with appropriate timing if refreshing is needed.

For example, the number of times the SOC of the nickel-metal hydride battery **40** becomes equal to the predetermined SOC is counted. Based on the counted number of times, it is possible to grasp the development of the memory effect of the nickel-metal hydride battery **40.** Then, it becomes easy to repeat the charging/discharging in the selected SOC use range, and it is also possible to refresh the nickel-metal hydride battery **40** with appropriate timing if refreshing is needed. By counting the number of times at a predetermined SOC that is included in all of the first and second use ranges **130, 140** and **150,** it is possible to precisely count the number of times without failing to count the number of times irrespective of which one of the first and second use ranges **130, 140** and **150** is selected.

In one embodiment, when it is determined that the current SOC is equal to the predetermined SOC, the microcontroller **61** may detect the voltage of the nickel-metal hydride battery **40** at the predetermined SOC by using information regarding the voltage of the nickel-metal hydride battery **40** detected by the voltage sensor **42,** and control the discharge of the nickel-metal hydride battery **40** by using the voltage of the nickel-metal hydride battery **40** at the predetermined SOC.

At the predetermined SOC that corresponds to the SOC lower limit **132** of the first use range **130,** the difference is small between the voltage along the discharge curve of the first use range **130** and the voltage along the discharge curve of the second use ranges **140** and **150.** The voltage of the nickel-metal hydride battery **40** at a point in time when the SOC becomes equal to the predetermined SOC, at which the voltage difference is small, is detected. By using the voltage value that is detected in the region where the voltage difference is small between the SOC use ranges **130, 140** and **150,** it is possible to precisely detect the voltage drop due to the memory effect.

In one embodiment, when the microcontroller **61** determines whether the voltage at the predetermined SOC is less than or equal to a predetermined voltage and it is determined that the voltage at the predetermined SOC is less than or equal to the predetermined voltage, a control of refreshing the nickel-metal hydride battery **40** may be performed.

By using the voltage value that is detected in the region where the voltage difference is small between the SOC use ranges **130, 140** and **150,** it is possible to precisely detect the voltage drop due to the memory effect. By precisely detecting the voltage drop due to the memory effect, it is possible to refresh the nickel-metal hydride battery **40** with appropriate timing.

In one embodiment, the microcontroller **61** may correct the value of the detected voltage in accordance with the currently-selected SOC use range of the SOC use ranges **130, 140** and **150.**

The voltage value at the predetermined SOC somewhat varies between different SOC use ranges. By correcting the voltage value in accordance with the currently-selected SOC use range, it is possible to more precisely detect the voltage drop due to the memory effect.

In one embodiment, the microcontroller **61** may count the number of times the SOC of the nickel-metal hydride battery **40** becomes equal to the predetermined SOC, determine whether the counted number of times is greater than or equal to a predetermined number of times, and if the counted number of times is greater than or equal to the predetermined number of times, perform a control of refreshing the nickel-metal hydride battery **40.**

As the nickel-metal hydride battery **40** is repeatedly charged/discharged, the memory effect develops, thereby decreasing the voltage that is obtained while discharging. When the counted number of times becomes greater than or equal to the predetermined number of times, the nickel-metal hydride battery **40** is refreshed. Thus, it is possible to restore the voltage that is obtained while discharging.

By counting the number of times at a predetermined SOC that is included in all of the first and second use ranges **130, 140** and **150,** it is possible to precisely count the number of times without failing to count the number of times irrespective of which one of the first and second use ranges **130, 140** and **150** is selected.

In one embodiment, the microcontroller **61** may count the number of times the SOC of the nickel-metal hydride battery **40** becomes equal to the predetermined SOC, and set the lower limits of the voltages of the discharge curves of the SOC use ranges **130, 140** and **150** to be lower than the current set values depending on the counted number of times.

The lower limit of the voltage of the discharge curve is lowered depending on the voltage drop due to the memory effect. Thus, it is possible to suppress narrowing of the SOC range that is actually used even if the memory effect develops.

In one embodiment, the predetermined SOC may be lower than 50% and greater than or equal to the SOC lower limit **132** of the first use range **130.**

The memory effect is likely to occur particularly in the region where SOC is less than 50% as compared with the region where SOC is 50% or more. As the region where information regarding the memory effect is obtained is set to the region where SOC is less than 50%, it is possible to perform a more appropriate discharge control.

In one example not covered by the present invention, the microcontroller **61** may use information regarding the current of the nickel-metal hydride battery **40** detected by the current sensor **43** to calculate the cumulative value of the current that is output from the nickel-metal hydride battery **40** and calculate the current SOC of the nickel-metal hydride battery **40** using the cumulative value of the current.

By using the cumulative current value, it would be possible to grasp the current SOC without using the voltage value of the nickel-metal hydride battery 40, thus departing from the present invention.

In one embodiment, the SOC upper limit **131** of the first use range **130** may be higher than the SOC upper limits **141** and **151** of the second use ranges **140** and **150,** and the SOC lower limits **142** and **152** of the second use ranges **140** and **150** may be lower than the SOC lower limit **132** of the first use range **130.**

By selectively using the first use range **130** having a high SOC upper limit and the second use ranges **140** and **150** having low SOC lower limits, it is possible to charge/discharge over a wide SOC range.

In one embodiment, a plurality of SOC use ranges further include the third use range **140,** wherein the SOC upper limit **141** of the third use range **140** is lower than the SOC upper limit **131** of the first use range **130** and higher than the SOC upper limit **151** of the second use range **150,** the SOC lower limit **142** of the third use range **140** is lower than the SOC lower limit **132** of the first use range **130** and higher than the SOC lower limit **152** of the second use range **150,** and the third use range **140** may include a predetermined SOC that corresponds to the SOC lower limit **132** of the first use range **130.**

By selectively using the first, second and third use ranges **130, 140** and **150,** it is possible to charge/discharge over a wide SOC range.

The predetermined SOC that corresponds to the SOC lower limit **132** of the first use range **130** is included in all of the first, second and third use ranges **130, 140** and **150.** Irrespective of which one of the first, second and third use ranges **130, 140** and **150** is selected, there exists a point in time at which the SOC of the nickel-metal hydride battery **40** becomes equal to the predetermined SOC as the SOC transitions. When it is determined that the current SOC of the nickel-metal hydride battery **40** is equal to the predetermined SOC, information regarding the memory effect is obtained. Then, it is possible to precisely detect the memory effect.

In one embodiment, the microcontroller **61** may change the SOC use range to be selected, from among the SOC use ranges **130, 140** and **150,** depending on the temperature of the nickel-metal hydride battery **40.**

By selectively using the SOC use ranges **130, 140** and **150** depending on the temperature of the nickel-metal hydride battery **40,** it is possible to charge/discharge over a wide SOC range. Being able to charge/discharge over a wide SOC range, it is possible to make effective use of the performance of the nickel-metal hydride battery **40.**

In one embodiment, the predetermined SOC may be the level of the SOC lower limit **132** of the first use range **130.**

The SOC of the level at the lower limit **132** of the first use range **130** is included in each of the use ranges **130, 140** and **150.** Irrespective of which one of the use ranges **130, 140** and **150** is selected, there exists a point in time at which the SOC of the nickel-metal hydride battery **40** becomes equal to the predetermined SOC as the SOC transitions. When it is determined that the current SOC of the nickel-metal hydride battery **40** is equal to the predetermined SOC, information regarding the memory effect is obtained. Thus, it is possible to precisely detect the memory effect.

In one embodiment, at the time of initial use of the nickel-metal hydride battery **40,** the microcontroller **61** may perform a control of: charging the nickel-metal hydride battery **40** to the SOC upper limit **131** of the first use range **130;** discharging the nickel-metal hydride battery **40** to the lower limit of the SOC use range selected depending on the condition of use of the nickel-metal hydride battery **40** after charging the nickel-metal hydride battery **40** to the SOC upper limit **131** of the first use range **130;** and charging the nickel-metal hydride battery **40** to the SOC upper limit **141, 151** of the second use range **140, 150** selected depending on the condition of use of the nickel-metal hydride battery **40** after discharging the nickel-metal hydride battery **40** to the lower limit of the selected SOC use range.

By discharging to the SOC lower limit **152** of the second use range **150** and charging to the SOC upper limit **131** of the first use range **130,** the discharge curve **123** and the charge curve **124** (a discharge curve and a charge curve that are to be the reference) are obtained that connect together the SOC upper limit **131** of the first use range **130** and the SOC lower limit **152** of the second use range **150.**

At the time of initial use of the nickel-metal hydride battery **40,** the discharge curve obtained when the second use ranges **140** and **150** are selected is apart from the discharge curve to be the reference. In the process of repeating a control of changing the SOC use range depending on the condition of use of the nickel-metal hydride battery **40,** the discharge curves of the second use ranges **140** and **150** move closer to the discharge curve to be the reference. If the discharge curves of the second use ranges **140** and **150** move in the process of repeating a control of changing the SOC use range, it is difficult to precisely detect the memory effect.

In view of this, at the time of initial use of the nickel-metal hydride battery **40,** the nickel-metal hydride battery **40** is charged to the SOC upper limit **131** of the first use range **130,** and then discharged to the lower limit of the SOC use range selected depending on the condition of use of the nickel-metal hydride battery **40.** After discharged to the lower limit, the nickel-metal hydride battery **40** is charged to the upper limit **141, 151** of the second use range **140, 150** selected depending on the condition of use. Thus, the discharge curves of the second use ranges **140** and **150** can immediately be made to conform to the discharge curve to be the reference. After the discharge curves of the second use ranges **140** and **150** are made to conform to the discharge curve to be the reference, the discharge curves do not move except by the influence of the memory effect. As the discharge curves of the second use ranges **140** and **150** no longer move except by the influence of the memory effect, it is possible to precisely detect the memory effect.

In one embodiment, the initial use of the nickel-metal hydride battery **40** may be the first use of the nickel-metal hydride battery **40** after shipping.

Immediately after starting to use the nickel-metal hydride battery **40,** the discharge curves of the second use ranges **140** and **150** can be made to confirm to the discharge curve to be the reference. As the discharge curves of the second use ranges **140** and **150** no longer move except by the influence of the memory effect, it is possible to precisely detect the memory effect.

In one embodiment, the initial use of the nickel-metal hydride battery **40** may be the first use of the nickel-metal hydride battery **40** after replenishing charging.

Immediately after starting to use the nickel-metal hydride battery **40** after replenishing charging, the discharge curves of the second use ranges **140** and **150** can be made to conform to the discharge curve to be the reference. As the discharge curves of the second use ranges **140** and **150** no longer move except by the influence of the memory effect, it is possible to precisely detect the memory effect.

A straddled vehicle **100** according to the embodiment includes the battery control system **6** described above.

Being able to charge/discharge the nickel-metal hydride battery **40** over a wide SOC range and to appropriately control the memory effect, it is possible to improve the performance of the straddled vehicle **100.**

### INDUSTRIAL APPLICABILITY

The present invention is particularly useful in technical fields where a nickel-metal hydride battery is charged/discharged.

### REFERENCE SIGNS LIST

1: Vehicle body, 2: Front fork, 3: Front wheel, 4: Handle, 5: Seat, 6: ECU (battery control system), 7: Rear wheel, 8: Leg space, 9: Head pipe, 10: Body frame, 11: Piston, 12: Conrod, 13: Crank shaft, 15: Intake valve, 16: Exhaust valve, 17: Cam shaft, 17a: Cam journal, 17b: Cam journal, 18: Injector, 19: Ignitor, 20: Engine, 21: Intake port, 22: Intake passageway, 23: Exhaust port, 24: Exhaust passageway, 25: Combustion chamber, 30: Rotating electric machine, 31: Stator, 31a: Stator coil, 32: Rotor, 32a: Magnet, 40: Nickel-metal hydride battery, 41: Temperature sensor, 42: Voltage sensor, 43: Current sensor, 61: Microcontroller (control circuit), 62: Memory (storage medium), 100: Motorcycle (straddled vehicle), 113: Discharge curve, 114: Charge curve, 120: SOC use range, 121: Upper limit of SOC use range, 122: Lower limit of SOC use range, 123: Discharge curve, 124: Charge curve, 130: SOC use range for low temperature, 131: Upper limit of SOC use range for low temperature, 132: Lower limit of SOC use range for low temperature, 133: Discharge curve, 134: Charge curve, 140: SOC use range for medium temperature, 141: Upper limit of SOC use range for medium temperature, 142: Lower limit of SOC use range for medium temperature, 143: Discharge curve, 144: Charge curve, 150: SOC use range for high temperature, 151: Upper limit of SOC use range for high temperature, 152: Lower limit of SOC use range for high temperature, 153: Discharge curve, 154: Charge curve

## Claims

1. A battery control system (6) for controlling charging/discharging of a nickel-metal hydride battery (40) having a hysteresis characteristic for a relationship between voltage and a state of charge, the battery control system (6) comprising:
a storage medium (62) configured to store information regarding a plurality of state of charge use ranges having different state of charge upper and lower limits; and
a control circuit (61) configured to select one of the plurality of state of charge use ranges depending on a condition of use according to a temperature of the nickel-metal hydride battery (40) to control the charging/discharging of the nickel-metal hydride battery (40) in accordance with the selected state of charge use range, wherein:
the plurality of state of charge use ranges include a first use range (130), and a second use range (150) that includes an state of charge of the same level as the state of charge lower limit (132) of the first use range (130), **characterized in that** the control circuit (61) is configured:
to detect a voltage of the nickel-metal hydride battery (40) and calculate the state of charge therefrom;
to determine whether a current state of charge of the nickel-metal hydride battery (40) is equal to a predetermined state of charge that is included in both the first use range (130) and the second use range (150);
when it is determined that the current state of charge is equal to the predetermined state of charge, to obtain information regarding a memory effect of the nickel-metal hydride battery (40); and
to control the discharging of the nickel-metal hydride battery (40) by lowering a lower limit voltage of each of the state of charge use ranges using the obtained information regarding the memory effect.

2. The battery control system (6) according to claim 1, wherein the control circuit (61) is configured:
when it is determined that the current state of charge is equal to the predetermined state of charge, to detect the voltage of the nickel-metal hydride battery (40) at the predetermined state of charge using information regarding the voltage of the nickel-metal hydride battery (40) detected by a voltage sensor (42); and
to control the discharging of the nickel-metal hydride battery (40) using the voltage of the nickel-metal hydride battery (40) at the predetermined state of charge.

3. The battery control system (6) according to claim 2, wherein the control circuit (61) is configured:
to determine whether the voltage at the predetermined state of charge is less than or equal to a predetermined voltage; and
when it is determined that the voltage at the predetermined state of charge is less than or equal to the predetermined voltage, to perform a control of refreshing the nickel-metal hydride battery (40).

4. The battery control system (6) according to claim 2 or 3, wherein the control circuit (61) is configured to correct a value of the detected voltage in accordance with the currently-selected state of charge use range of the plurality of state of charge use ranges.

5. The battery control system (6) according to any one of claims 1 to 4, wherein the control circuit (61) is configured:
to count the number of times the state of charge of the nickel-metal hydride battery (40) becomes equal to the predetermined state of charge;
to determine whether the counted number of times is greater than or equal to a predetermined number of times; and
when it is determined that the counted number of times is greater than or equal to the predetermined number of times, to perform a control of refreshing the nickel-metal hydride battery (40).

6. The battery control system (6) according to any one of claims 1 to 5, wherein control circuit (61) is configured:
to count the number of times the state of charge of the nickel-metal hydride battery (40) becomes equal to the predetermined state of charge; and
to set a lower limit of a voltage of a discharge curve of each of the plurality of state of charge use ranges to be lower than a current set value depending on the counted number of times.

7. The battery control system (6) according to any one of claims 1 to 6, wherein the predetermined state of charge is smaller than 50% and greater than or equal to the state of charge lower limit (132) of the first use range (130).

8. The battery control system (6) according to any one of claims 1 to 7, wherein state of charge upper limit (131) of the first use range (130) is higher than the state of charge upper limit (151) of the second use range (150); and the state of charge lower limit (152) of the second use range (150) is lower than the state of charge lower limit (132) of the first use range (130).

9. The battery control system (6) according to any one of claims 1 to 8, wherein the plurality of state of charge use ranges further include a third use range (140);
an state of charge upper limit (141) of the third use range (140) is lower than the state of charge upper limit (131) of the first use range (130) and higher than the state of charge upper limit (151) of the second use range (150);
an state of charge lower limit (142) of the third use range (140) is lower than the state of charge lower limit (132) of the first use range (130) and higher than the state of charge lower limit (152) of the second use range (150); and
the third use range (140) includes the predetermined state of charge.

10. The battery control system (6) according to any one of claims 1 to 9, wherein the predetermined state of charge is of a level of the state of charge lower limit (132) of the first use range (130).

11. The battery control system (6) according to any one of claims 1 to 10, wherein at the time of initial use of the nickel-metal hydride battery (40), the control circuit (61) is configured:
to charge the nickel-metal hydride battery (40) to the state of charge upper limit (131) of the first use range (130);
after charging the nickel-metal hydride battery (40) to the state of charge upper limit (131) of the first use range (130), to discharge the nickel-metal hydride battery (40) to the lower limit of the state of charge use range selected depending on a condition of use according to a temperature of the nickel-metal hydride battery (40); and
after discharging the nickel-metal hydride battery (40) to the lower limit of the selected state of charge use range, to charge the nickel-metal hydride battery (40) to the state of charge upper limit (151) of the second use range (150) selected depending on the condition of use according to the temperature of the nickel-metal hydride battery (40).

12. The battery control system (6) according to claim 11, wherein the initial use of the nickel-metal hydride battery (40) is a first use of the nickel-metal hydride battery (40) after shipping of the nickel-metal hydride battery (40).

13. The battery control system (6) according to claim 11, wherein the initial use of the nickel-metal hydride battery (40) is a first use of the nickel-metal hydride battery (40) after replenishing charging of the nickel-metal hydride battery (40).

14. A straddled vehicle comprising the battery control system (6) according to any one of claims 1 to 13.

## Patentansprüche

1. Ein Batteriesteuersystem (6) zum Steuern des Ladens/Entladens einer Nickel-Metallhydrid-Batterie (40), die eine Hysterese-Charakteristik für eine Beziehung zwischen der Spannung und einem Ladezustand hat, das Batteriesteuersystem (6) umfasst:
ein Speichermedium (62), das konfiguriert ist, um Informationen bezüglich einer Mehrzahl von Ladezustands-Nutzungsbereichen, die unterschiedliche Ladezustands-Ober und -Untergrenzen haben, speichert; und
ein Steuerkreis (61), die konfiguriert ist, um einen der Mehrzahl der Ladezustands-Nutzungsbereiche in Abhängigkeit von einer Verwendungsbedingung gemäß einer Temperatur der Nickel-Metallhydrid-Batterie (40) auswählt, um das Laden/Entladen der Nickel-Metallhydrid-Batterie (40) in Übereinstimmung mit dem ausgewählten Ladezustands-Nutzungsbereich zu steuern, wobei:
die Mehrzahl der Ladezustands-Nutzungsbereiche einen ersten Nutzungsbereich (130) und einen zweiten Nutzungsbereich (150) beinhalten, der einen Ladezustand auf demselben Niveau wie die Ladezustands-Untergrenze (132) des ersten Nutzungsbereichs (130) aufweist, **dadurch gekennzeichnet, dass** der Steuerkreis (61) konfiguriert ist:
um eine Spannung der Nickel-Metallhydrid-Batterie (40) zu erfassen und daraus den Ladezustand zu berechnen;
zu bestimmen, ob ein aktueller Ladezustand der Nickel-Metallhydrid-Batterie (40) gleich einem vorbestimmten Ladezustand ist, der in beiden, dem ersten Nutzungsbereich (130) und dem zweiten Nutzungsbereich (150) enthalten ist;
wenn festgestellt wird, dass der aktuelle Ladezustand gleich dem vorbestimmten Ladezustand ist, um Informationen bezüglich eines Memory-Effekts der Nickel-Metallhydrid-Batterie (40) zu erhalten; und
die Entladung der Nickel-Metallhydrid-Batterie (40) zu steuern, indem eine untere Grenzspannung jedes der Ladezustands-Nutzungsbereiche unter Verwendung der erhaltenen Informationen über den Memory-Effekt abgesenkt wird.

2. Das Batteriesteuersystem (6) gemäß Anspruch 1, wobei der Steuerkreis (61) konfiguriert ist:
wenn festgestellt wird, dass der aktuelle Ladezustand gleich dem vorbestimmten Ladezustand ist, um die Spannung der Nickel-Metallhydrid-Batterie (40) bei dem vorbestimmten Ladezustand unter Verwendung von Informationen bezüglich der Spannung der Nickel-Metallhydrid-Batterie (40), die von einem Spannungssensor (42) erfasst werden, zu erfassen; und
um Entladen der Nickel-Metallhydrid-Batterie (40) anhand der Spannung der Nickel-Metallhydrid-Batterie (40) bei dem vorbestimmten Ladezustand zu steuern.

3. Das Batteriesteuersystem (6) gemäß Anspruch 2, wobei der Steuerkreis (61) so konfiguriert ist:
um festzustellen, ob die Spannung bei dem vorbestimmten Ladezustand kleiner oder gleich einer vorbestimmten Spannung ist; und
wenn festgestellt wird, dass die Spannung bei dem vorbestimmten Ladezustand kleiner oder gleich der vorbestimmten Spannung ist, eine Steuerung zum Auffrischen der Nickel-Metallhydrid-Batterie (40) durchzuführen.

4. Das Batteriesteuersystem (6) gemäß Anspruch 2 oder 3, wobei der Steuerkreis (61) konfiguriert ist, um einen Wert der erfassten Spannung in Übereinstimmung mit dem aktuell gewählten Ladezustands-Nutzungsbereich aus der Mehrzahl der Ladezustands-Nutzungsbereiche zu korrigieren.

5. Das Batteriesteuersystem (6) gemäß irgendeinem der Ansprüche 1 bis 4, wobei der Steuerkreis (61) konfiguriert ist:
um zu zählen, wie oft der Ladezustand der Nickel-Metallhydrid-Batterie (40) gleich dem vorbestimmten Ladezustand wird;
zu bestimmen, ob die gezählte Anzahl von Malen größer oder gleich einer vorbestimmten Anzahl von Malen ist; und
wenn festgestellt wird, dass die gezählte Anzahl von Malen größer oder gleich der vorbestimmten Anzahl von Malen ist, eine Steuerung zum Auffrischen der Nickel-Metallhydrid-Batterie (40) durchzuführen.

6. Das Batteriesteuersystem (6) gemäß irgendeinem der Ansprüche 1 bis 5, wobei der Steuerkreis (61) konfiguriert ist:
Um die Anzahl der Male zu zählen, in denen der Ladezustand der Nickel-Metallhydrid-Batterie (40) gleich dem vorbestimmten Ladezustand wird; und
um eine untere Grenze einer Spannung einer Entladungskurve jedes der Mehrzahl der Ladezustands-Nutzungsbereiche einzustellen, so dass sie niedriger ist als ein aktueller Sollwert in Abhängigkeit von der gezählten Anzahl von Malen.

7. Das Batteriesteuersystem (6) gemäß irgendeinem der Ansprüche 1 bis 6, wobei der vorbestimmte Ladezustand kleiner als 50 % und größer als oder gleich der Ladezustands-Untergrenze (132) des ersten Nutzungsbereichs (130) ist.

8. Das Batteriesteuersystem (6) gemäß irgendeinem der Ansprüche 1 bis 7, wobei die Ladezustands-Obergrenze (131) des ersten Nutzungsbereichs (130) höher ist als die Ladezustands-Obergrenze (151) des zweiten Nutzungsbereichs (150); und
die Ladezustands-Untergrenze (152) des zweiten Nutzungsbereichs (150) niedriger ist als die Ladezustands-Untergrenze (132) des ersten Nutzungsbereichs (130).

9. Das Batteriesteuersystem (6) gemäß irgendeinem der Ansprüche 1 bis 8, wobei die Mehrzahl der Ladezustands-Nutzungsbereiche ferner einen dritten Nutzungsbereich (140) enthält;
eine Ladezustands-Obergrenze (141) des dritten Nutzungsbereichs (140) niedriger als die Ladezustands-Obergrenze (131) des ersten Nutzungsbereichs (130) und höher als die Ladezustands-Obergrenze (151) des zweiten Nutzungsbereichs (150) ist;
eine Ladezustands-Untergrenze (142) des dritten Nutzungsbereichs (140) niedriger ist als die Ladezustands-Untergrenze (132) des ersten Nutzungsbereichs (130) und höher als die Ladezustands-Untergrenze (152) des zweiten Nutzungsbereichs (150); und
der dritte Nutzungsbereich (140) den vorbestimmten Ladezustand enthält.

10. Das Batteriesteuersystem (6) gemäß irgendeinem der Ansprüche 1 bis 9, wobei der vorbestimmte Ladezustand auf dem Niveau der Ladezustands-Untergrenze (132) des ersten Nutzungsbereichs (130) liegt.

11. Das Batteriesteuersystem (6) gemäß irgendeinem der Ansprüche 1 bis 10, wobei der Steuerkreis (61) zum Zeitpunkt der erstmaligen Verwendung der Nickel-Metallhydrid-Batterie (40) konfiguriert ist:
um die Nickel-Metallhydrid-Batterie (40) bis zu der Ladezustands-Obergrenze (131) des ersten Nutzungsbereichs (130) zu laden;
nach dem Laden der Nickel-Metallhydrid-Batterie (40) bis zu der Ladezustands-Obergrenze (131) des ersten Nutzungsbereichs (130), um die Nickel-Metallhydrid-Batterie (40) bis zu der unteren Grenze des Nutzungsbereichs des Ladezustands, der in Abhängigkeit von einem Nutzungszustand gemäß der Temperatur der Nickel-Metallhydrid-Batterie (40) ausgewählt wird, zu entladen; und
nach dem Entladen der Nickel-Metallhydrid-Batterie (40) auf die untere Grenze des gewählten Ladezustands-Nutzungsbereichs die Nickel-Metallhydrid-Batterie (40) auf die Ladezustands-Obergrenze (151) des zweiten Nutzungsbereichs (150) zu laden, der in Abhängigkeit vom Nutzungszustand gemäß der Temperatur der Nickel-Metallhydrid-Batterie (40) gewählt ist.

12. Das Batteriesteuersystem (6) gemäß Anspruch 11, wobei die erste Verwendung der Nickel-Metallhydrid-Batterie (40) eine erste Verwendung der Nickel-Metallhydrid-Batterie (40) nach dem Versand der Nickel-Metallhydrid-Batterie (40) ist.

13. Das Batteriesteuersystem (6) gemäß Anspruch 11, wobei die erste Verwendung der Nickel-Metallhydrid-Batterie (40) eine erste Verwendung der Nickel-Metallhydrid-Batterie (40) nach dem Wiederaufladen der Nickel-Metallhydrid-Batterie (40) ist.

14. Ein Spreiz-Sitz-Fahrzeug mit dem Batteriesteuersystem (6) gemäß irgendeinem der Ansprüche 1 bis 13.

## Revendications

1. Système de contrôle de batterie (6) pour contrôler la charge/décharge d'une batterie nickel-hydrure métallique (40) ayant une caractéristique d'hystérésis pour une relation entre la tension et l'état de charge, le système de contrôle de batterie (6) comprenant :
un support de stockage (62) configuré pour stocker de l'information concernant une pluralité de plages d'utilisation d'état de charge ayant différentes limites supérieure et inférieure d'état de charge ; et
un circuit de contrôle (61) configuré pour sélectionner une plage de la pluralité de plages d'utilisation d'état de charge en fonction d'une condition d'utilisation conformément à une température de la batterie nickel-hydrure métallique (40) pour contrôler la charge/décharge de la batterie nickel-hydrure métallique (40) conformément à la plage d'utilisation d'état de charge sélectionnée, dans lequel :
la pluralité de plages d'utilisation d'état de charge comprend une première plage d'utilisation (130) et une deuxième plage d'utilisation (150) qui comprend un état de charge du même niveau que la limite inférieure d'état de charge (132) de la première plage d'utilisation (130),
**caractérisé en ce que** le circuit de contrôle (61) est configuré :
pour détecter une tension de la batterie nickel-hydrure métallique (40) et calculer son état de charge ;
pour déterminer si un état de charge actuel de la batterie nickel-hydrure métallique (40) est ou non égal à un état de charge prédéterminé qui est inclus à la fois dans la première plage d'utilisation (130) et la deuxième plage d'utilisation (150) ;
quand il est déterminé que l'état de charge actuel est égal à l'état de charge prédéterminé, pour obtenir de l'information concernant un effet de mémoire de la batterie nickel-hydrure métallique (40) ; et
pour contrôler la décharge de la batterie nickel-hydrure métallique (40) en abaissant une tension limite inférieure de chacune des plages d'utilisation de l'état de charge en utilisant l'information obtenue concernant l'effet de mémoire.

2. Système de contrôle de batterie (6) selon la revendication 1, dans lequel le circuit de contrôle (61) est configuré :
quand il est déterminé que l'état de charge actuel est égal à l'état de charge prédéterminé, pour détecter la tension de la batterie nickel-métal hydrure (40) à l'état de charge prédéterminé en utilisant de l'information concernant la tension de la batterie nickel-métal hydrure (40) détectée par un capteur de tension (42) ; et
pour contrôler la décharge de la batterie nickel-hydrure métallique (40) en utilisant la tension de la batterie nickel-hydrure métallique (40) à l'état de charge prédéterminé.

3. Système de contrôle de batterie (6) selon la revendication 2, dans lequel le circuit de contrôle (61) est configuré :
pour déterminer si la tension à l'état de charge prédéterminé est ou non inférieure ou égale à une tension prédéterminée ; et
quand il est déterminé que la tension à l'état de charge prédéterminé est inférieure ou égale à la tension prédéterminée, pour mettre en oeuvre un contrôle de rafraîchissement de la batterie nickel-hydrure métallique (40) .

4. Système de contrôle de batterie (6) selon la revendication 2 ou 3, dans lequel le circuit de contrôle (61) est configuré pour corriger une valeur de la tension détectée conformément à la plage d'utilisation d'état de charge actuellement sélectionnée parmi la pluralité de plages d'utilisation d'état de charge.

5. Système de contrôle de batterie (6) selon l'une quelconque des revendications 1 à 4, dans lequel le circuit de contrôle (61) est configuré :
pour compter le nombre de fois où l'état de charge de la batterie nickel-hydrure métallique (40) devient égal à l'état de charge prédéterminé ;
pour déterminer si le nombre de fois compté est ou non supérieur ou égal à un nombre de fois prédéterminé ; et
lorsqu'il est déterminé que le nombre de fois compté est supérieur ou égal au nombre de fois prédéterminé, pour mettre en oeuvre un contrôle de rafraîchissement de la batterie nickel-hydrure métallique (40).

6. Système de contrôle de batterie (6) selon l'une quelconque des revendications 1 à 5, dans lequel le circuit de contrôle (61) est configuré :
pour compter le nombre de fois où l'état de charge de la batterie nickel-hydrure métallique (40) devient égal à l'état de charge prédéterminé ; et
pour définir une limite inférieure de tension d'une courbe de décharge de chaque plage de la pluralité de plages d'utilisation d'état de charge à une valeur inférieure à une valeur de consigne actuelle en fonction du nombre de fois compté.

7. Système de contrôle de batterie (6) selon l'une quelconque des revendications 1 à 6, dans lequel l'état de charge prédéterminé est inférieur à 50 % et supérieur ou égal à la limite inférieure d'état de charge (132) de la première plage d'utilisation (130).

8. Système de contrôle de batterie (6) selon l'une quelconque des revendications 1 à 7, dans lequel
la limite supérieure d'état de charge (131) de la première plage d'utilisation (130) est supérieure à la limite supérieure d'état de charge (151) de la deuxième plage d'utilisation (150) ; et
la limite inférieure d'état de charge (152) de la deuxième plage d'utilisation (150) est inférieure à la limite inférieure d'état de charge (132) de la première plage d'utilisation (130).

9. Système de contrôle de batterie (6) selon l'une quelconque des revendications 1 à 8, dans lequel
la pluralité de plages d'utilisation d'état de charge comprend en outre une troisième plage d'utilisation (140) ;
une limite supérieure d'état de charge (141) de la troisième plage d'utilisation (140) est inférieure à la limite supérieure d'état de charge (131) de la première plage d'utilisation (130) et supérieure à la limite supérieure d'état de charge (151) de la deuxième plage d'utilisation (150) ;
une limite inférieure d'état de charge (142) de la troisième plage d'utilisation (140) est inférieure à la limite inférieure d'état de charge (132) de la première plage d'utilisation (130) et supérieure à la limite inférieure d'état de charge (152) de la deuxième plage d'utilisation (150) ; et
la troisième plage d'utilisation (140) comprend l'état de charge prédéterminé.

10. Système de contrôle de batterie (6) selon l'une quelconque des revendications 1 à 9, dans lequel l'état de charge prédéterminé est un niveau de limite inférieure d'état de charge (132) de la première plage d'utilisation (130).

11. Système de contrôle de batterie (6) selon l'une quelconque des revendications 1 à 10, dans lequel, au moment de l'utilisation initiale de la batterie nickel-hydrure métallique (40), le circuit de contrôle (61) est configuré :
pour charger la batterie nickel-métal hydrure (40) jusqu'à la limite supérieure d'état de charge (131) de la première plage d'utilisation (130) ;
après avoir chargé la batterie nickel-métal hydrure (40) jusqu'à la limite supérieure d'état de charge (131) de la première plage d'utilisation (130), pour décharger la batterie nickel-métal hydrure (40) jusqu'à la limite inférieure de la plage d'utilisation d'état de charge sélectionnée en fonction d'une condition d'utilisation selon une température de la batterie nickel-métal hydrure (40) ; et
après avoir déchargé la batterie nickel-hydrure métallique (40) jusqu'à la limite inférieure de la plage d'utilisation d'état de charge sélectionnée, pour charger la batterie nickel-métal hydrure (40) jusqu'à la limite supérieure d'état de charge (151) de la deuxième plage d'utilisation (150) sélectionnée en fonction de la condition d'utilisation conformément à la température de la batterie nickel-métal hydrure (40).

12. Système de contrôle de batterie (6) selon la revendication 11, dans lequel l'utilisation initiale de la batterie nickel-hydrure métallique (40) est une première utilisation de la batterie nickel-hydrure métallique (40) après la livraison de la batterie nickel-hydrure métallique (40) .

13. Système de contrôle de batterie (6) selon la revendication 11, dans lequel l'utilisation initiale de la batterie nickel-métal hydrure (40) est une première utilisation de la batterie nickel-métal hydrure (40) après avoir rétabli la charge de la batterie nickel-métal hydrure (40) .

14. Véhicule à enfourcher comprenant le système de contrôle de batterie (6) selon l'une quelconque des revendications 1 à 13.
